(19) Europäisches Patentamt
European Patent Office
Office européen des brevets

(11) **EP 2 710 634 B1**

(12) **FASCICULE DE BREVET EUROPEEN**

(45) Date de publication et mention
de la délivrance du brevet:
**07.10.2020 Bulletin 2020/41**

(21) Numéro de dépôt: **12728646.6**

(22) Date de dépôt: **10.05.2012**

(51) Int Cl.:
*H01L 27/15* (2006.01)    *H01L 33/62* (2010.01)
*H01L 33/24* (2010.01)    *H01L 33/06* (2010.01)
*H01L 29/15* (2006.01)    *H01L 29/06* (2006.01)

(86) Numéro de dépôt international:
**PCT/FR2012/051033**

(87) Numéro de publication internationale:
**WO 2012/156620 (22.11.2012 Gazette 2012/47)**

(54) **CONNEXION ELECTRIQUE EN SERIE DE NANOFILS EMETTEURS DE LUMIERE**

ELEKTRISCHE REIHENSCHALTUNG VON LICHTEMITTIERENDEN NANODRÄHTEN

IN-SERIES ELECTRICAL CONNECTION OF LIGHT-EMITTING NANOWIRES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.05.2011 FR 1154313**

(43) Date de publication de la demande:
**26.03.2014 Bulletin 2014/13**

(73) Titulaire: **Commissariat à l'Énergie Atomique et aux Énergies Alternatives**
**75015 Paris (FR)**

(72) Inventeurs:
• **BAVENCOVE, Anne-Laure**
**F-31110 Moustajon (FR)**
• **GILET, Philippe**
**F-38470 Teche (FR)**
• **MOLLER, Pierre**
**F-78000 Versailles (FR)**

(74) Mandataire: **Cabinet Laurent & Charras**
**Le Contemporain**
**50 Chemin de la Bruyère**
**69574 Dardilly Cedex (FR)**

(56) Documents cités:
WO-A1-2006/080609    WO-A1-2010/071594
WO-A1-2011/020959    US-A1- 2010 136 414
US-B2- 7 535 028

**Description**

**DOMAINE DE L'INVENTION**

L'invention a trait aux dispositifs optoélectroniques à base de nanofils pour la production de lumière, notamment des LED (diodes électroluminescentes).

**ETAT DE LA TECHNIQUE**

De manière schématique, une LED comporte une zone semi-conductrice pour l'injection d'électrons, une zone semi-conductrice pour l'injection de trous et une zone semi-conductrice dite « active » dans laquelle les électrons et les trous injectés se recombinent de manière radiative.

La première technologie utilisée pour fabriquer des LEDs est la technologie dite « planaire ». La technologie planaire posant un certain nombre de problèmes, notamment en termes d'efficacité quantique et/ou en termes d'accord de maille entre les différents matériaux utilisés et/ou en termes de limitation de longueur d'onde qu'il est possible d'émettre, des LEDs à base de nanofils ayant des structures de confinement à multi-puits quantiques ont été développées. Ces nanofils, et plus particulièrement leur procédé de fabrication, présentent en effet un certain nombre d'avantages, notamment :

- une croissance de nanofils sur substrats, chacun pouvant être constitué d'un matériau désaccordé en paramètre de maille l'un par rapport à l'autre. Ainsi, le silicium, qui est un substrat à bas coût, fabricable à grande taille et conducteur, peut être envisagé pour la croissance de nanofils en matériau III-N, ce qui est impossible en technologie planaire. Cette alternative présente des avantages à la fois en termes de coût de production et de simplification des procédés de fabrication, notamment au niveau de l'injection électrique ;
- une bonne qualité cristalline due à la relaxation des contraintes aux surfaces libres. Ainsi on observe naturellement une diminution du nombre de centres de recombinaisons non-radiatifs par rapport aux structures planaires, et notamment une absence de dislocations traversantes dommageables pour l'efficacité quantique des LEDs ; et
- une meilleure extraction de la lumière sans complexification des procédés de fabrication.

On distingue dans l'état de la technique deux catégories de nanofils entrant dans la constitution des LEDs:

- celle dont la zone active des nanofils comprend des structures de confinement à multi-puits quantiques épitaxiés axialement, c'est-à-dire selon l'axe de croissance des nanofils,
- et celle dont la zone active des nanofils comprend des structures de confinement à multi-puits quantiques épitaxiés radialement, c'est-à-dire dans un volume formé autour de l'axe de croissance des nanofils.

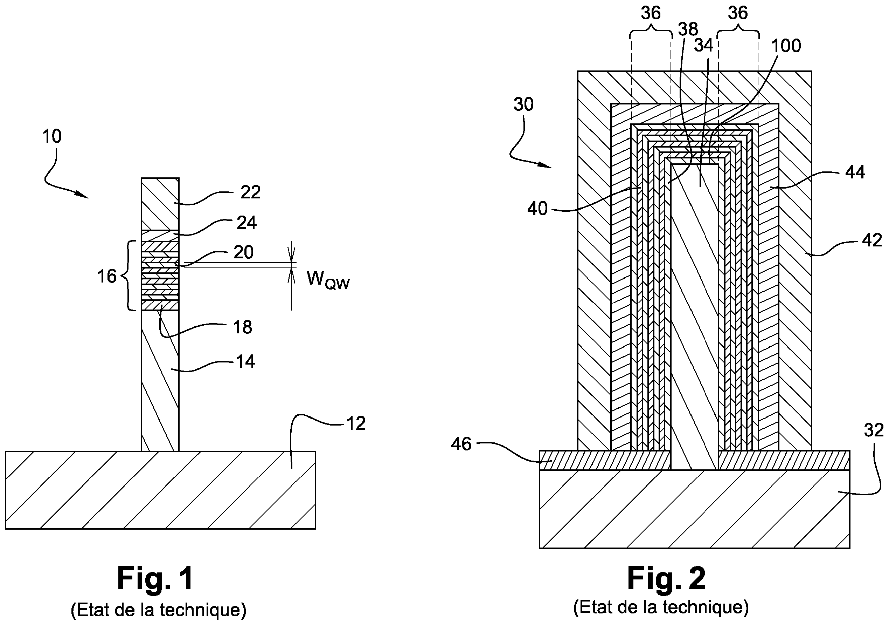

Sur la figure 1, il est représenté de manière schématique en coupe un exemple de nanofil formant une nano-LED **10** à multi-puits quantiques épitaxiés axialement. La nano-LED **10** est formée d'une zone **14** en GaN dopée n par du silicium, formée sur un substrat en silicium dopé n+ **12,** sur laquelle est formée une zone active **16** constituée de multi-puits quantiques axiaux formés d'une alternance de zones de GaN **18** et de zones InGaN **20** non intentionnellement dopées. Une zone de GaN **22,** dopée p par du magnésium est par ailleurs déposée sur une zone bloqueuse d'électrons de AlGaN dopée p **24,** communément désignée par zone « EBL » (pour « *Electron Blocking Layer* »), elle-même déposée sur la zone active **16.**

Selon cette géométrie axiale, les électrons et les trous sont injectés dans la zone active **16** respectivement au moyen du substrat **12,** via la zone **14,** et de la zone **22,** et se recombinent, au moins en partie de manière radiative dans les puits quantiques InGaN **20** de la zone active **16.**

Sur la figure 2, il est représenté de manière schématique en coupe un exemple de nanofil formant une nano-LED **30** à multi-puits quantiques épitaxiés radialement autour d'un cœur **34** lui-même déposé sur un substrat en silicium dopé n+ **32.** La nano-LED **30** comporte un cœur **34** constitué de GaN dopé n par du Silicium et une coquille comprenant la zone active **36** à multi-puits quantiques radiaux formés d'une alternance de zones de GaN **38** et de zones InGaN **40** non intentionnellement dopées, un volume EBL **44** entoure la zone active **36,** le volume EBL **44** étant lui-même entouré d'un volume de GaN dopé p **42** par du magnésium.

Les zones **36, 44** et **42** sont par ailleurs formées sur une couche d'isolation électrique **46,** le cœur **34** étant quant à lui formé directement au contact du substrat **32.**

Selon cette géométrie radiale, les électrons et les trous sont injectés dans la zone active **36** respectivement au moyen du substrat **32,** via le cœur **34,** et de la zone **42,** et se recombinent, au moins en partie de manière radiative dans les puits quantiques InGaN **40** de la zone active **36.** Une architecture de nanofil dans laquelle l'une des zones d'injection de trous et d'électrons forme une coquille enrobant, au moins partiellement, un cœur comprenant la zone active de recombinaison, est usuellement désignée sous l'expression de « *core/shell* ».

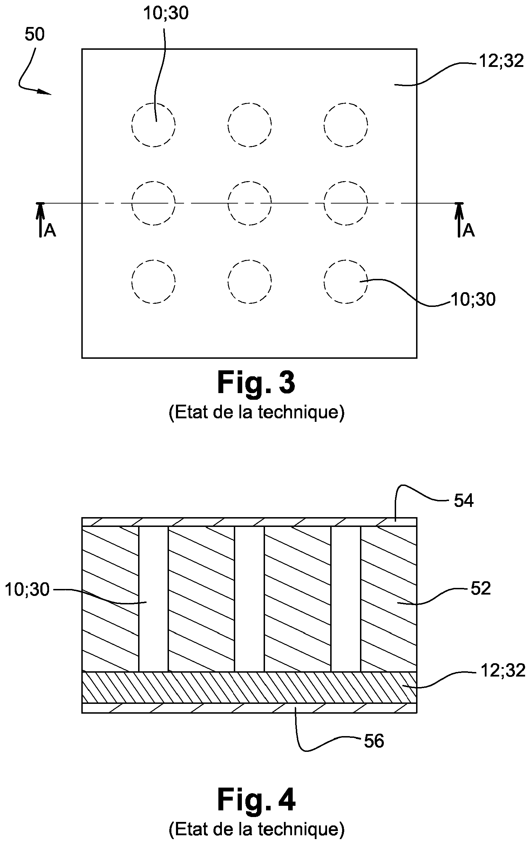

Quelle que soit la configuration axiale ou radiale des nanofils, l'alimentation électrique d'une matrice de nanofils est classiquement réalisée de manière parallèle. Un exemple de connexion parallèle est illustré aux figures 3 et 4, qui sont respectivement une vue schématique de dessus d'une LED comportant une matrice **50** de nanofils **10, 30,** dans l'exemple illustré une matrice de trois nanofils par trois nanofils, et une vue schématique en coupe selon le plan A-A de la figure 3.

Comme illustré, les nanofils **10, 30** sont noyés dans une couche planarisante **52** en matériau électriquement isolant et sont connectés en parallèle entre une électrode supérieure **54,** formée sur la couche **52,** et une électrode inférieure **56,** agencée sous le substrat **12, 32** sur lequel sont formés les nanofils **10, 30**. De nombreux schémas de connexion parallèles ont été conçus, des exemples étant décrits par exemple dans les documents US2005/0253138, US 2007/0057248, US 2008/0157057, WO2008/048704, WO2008/14061 let WO2010/071594.

Pour qu'un courant électrique puisse circuler dans un nanofil, il est nécessaire de soumettre celui-ci à une tension d'alimentation minimale, appelée « tension de seuil », dont la valeur dépend des propriétés morphologiques (hauteur, diamètre...), des propriétés structurales (niveau de dopage des matériaux semi-conducteurs en cause, qualité cristalline, composition des puits et des barrières...) du nanofil et de la qualité « locale » du contact avec le nanofil. Or, les nanofils présentent des tensions de seuil différentes en raison d'une dispersion des propriétés morphologiques et structurales, étant donné qu'il est impossible de fabriquer des nanofils strictement identiques.

Toutefois, une connexion en parallèle de nanofils impose une même différence de potentiels pour tous les nanofils. En cas de fluctuation importante dans les tensions de seuil des nanofils, il est donc difficile, voire impossible, de commuter tous les nanofils dans leur état passant de manière simultanée. En outre, une connexion parallèle peut créer des courts circuits des nanofils. En effet, en cas de nanofils défectueux, il se crée des chemins de conduction privilégiés et donc de forts courants de fuites. Ces inconvénients sont d'autant plus critiques compte tenu des faibles dimensions des nanofils, d'un diamètre usuellement compris entre quelques nanomètres à quelques micromètres et d'une hauteur comprise entre quelques centaines de nanomètres à quelques dizaines de micromètres, qui rendent leurs propriétés d'autant plus sensibles aux défauts.

De plus, l'intensité lumineuse d'une LED est fonction principalement de l'intensité du courant qui la traverse, et non pas de la valeur de tension d'alimentation appliquée aux électrodes d'alimentation. En imposant une différence de potentiel sensiblement identique pour tous les nanofils, et en raison des différences de propriétés de ces derniers, les courants électriques traversant le nanofils peuvent donc être différents, ce qui peut engendrer des variations importantes de puissance lumineuse émise d'un nanofil à l'autre.

Parallèlement, la connexion en série de dispositifs électroluminescents est connue et est par exemple décrite dans les documents US 7 535 028 et WO 2011/020959. Toutefois, la connexion en série concerne ici des dispositifs présentant de grandes dimensions latérales. Ainsi, le premier document fait référence à la connexion en série de LEDs planaires alors que le deuxième document considère la connexion de dispositifs LEDs regroupant des nanofils intercalés entre deux électrodes planes.

En raison du faible diamètre des nanofils, les techniques de connexion en série de l'état de la technique ne sont pas applicables. Notamment, il existe des barrières technologiques infranchissables compte tenu des dimensions mises en jeu et des procédés de croissance utilisés. Par exemple, on conçoit aisément que la connexion en série par un fil d'or du document WO 2011/020959 ne peut être employée pour connecter en série deux nanofils adjacents. De même, on conçoit aisément que la connexion en série décrite dans le document US 7 535 028, qui nécessite des flancs inclinés pour s'assurer du dépôt d'un contact métallique sur un passage de marche, ne peut être employée pour connecter en série deux nanofils sensiblement verticaux.

## EXPOSE DE L'INVENTION

Le but de la présente invention est de proposer une connexion électrique qui permet de connecter en série des nanofils émetteurs de lumière.

A cet effet, l'invention a pour objet un dispositif optoélectronique comportant au moins : ▪

- un premier et un deuxième nanofils émetteurs de lumière formés sur un support et comportant chacun une zone semi-conductrice d'un premier type pour l'injection de trous et une zone semi-conductrice d'un second type pour l'injection d'électrons ;
  - ▪ une connexion électrique en série des premier et deuxième nanofils émetteurs de lumière comportant :

    o un nanofil de connexion formé sur le support et comprenant :

      ▪ une première région apte à former avec la zone d'injection de trous du premier nanofil un chemin électrique permettant la circulation d'un courant électrique;

- une deuxième région apte à former avec la zone d'injection d'électrons du second nanofil un chemin électrique permettant la circulation d'un courant électrique ; et
- une troisième région au contact des première et deuxième régions permettant la circulation d'un courant électrique entre celles-ci ;

  ◦ une première zone conductrice connectant la zone d'injection de trous du premier nanofil et la première région du nanofil de connexion et électriquement isolée du deuxième nanofil ; et
  ◦ une deuxième zone conductrice connectant la deuxième région du nanofil de connexion et la zone d'injection d'électrons du deuxième nanofil et isolée électriquement du premier nanofil.

La principale difficulté à connecter des nanofils en série réside dans le fait que la zone d'injection de trous et la zone d'injection d'électrons sont disposées à l'opposée l'une de l'autre. La connexion série de deux nanofils, qui consiste à connecter la zone d'injection de trous d'un nanofil avec la zone d'injection d'électrons de l'autre nanofil nécessite donc le passage d'une marche. L'invention permet de franchir aisément cette marche en utilisant un nanofil. Cette marche étant ainsi franchie, il n'existe plus de barrière technologique dans la fabrication des autres éléments de la connexion série, à savoir les zones conductrices qui peuvent par exemple, mais non exclusivement, être réalisées au moyen d'une technique de fabrication planaire. En outre, le nanofil de connexion peut être du même type que les nanofils à connecter et donc fabriqués en même temps que les nanofils émetteurs de lumière.

Selon un mode de réalisation, chacun des premier et deuxième nanofils émetteurs de lumière comprend un cœur semi-conducteur, dont l'extrémité formée sur le support constitue l'une des zones parmi la zone d'injection de trous et la zone d'injection d'électrons, et une coquille semi-conductrice enrobant le cœur sur au moins une portion supérieure de celui-ci et constituant l'autre parmi la zone d'injection de trous et la zone d'injection d'électrons. En d'autres termes, les nanofils émetteurs de lumière se présentent selon une architecture dite de « core/shell ».

Plus particulièrement :

- le cœur des premier et deuxième nanofils est constitué d'un matériau semi-conducteur d'un première type de conductivité ;
- la coquille des premier et deuxième nanofils est constituée d'un matériau semi-conducteur d'un deuxième type de conductivité, opposé au premier type de conductivité ; et
- le nanofil de connexion comporte au moins un cœur constitué du matériau du premier type de conductivité.

Selon cette variante, les nanofils présentent donc une architecture « core/shell » comportant :

- une zone semi-conductrice active pour la recombinaison radiative de paires électrons-trous réalisées, à savoir le cœur du nanofil ;
- une zone semi-conductrice pour l'injection radiale de trous dans le ou chaque nanofil, à savoir la coquille ; et
- une zone semi-conductrice pour l'injection axiale d'électrons dans le ou chaque nanofil, à savoir l'extrémité du cœur au contact du support.

Par « injection axiale », il faut comprendre ici que l'injection des électrons dans la zone active est majoritairement réalisée selon la direction de croissance du nanofil. Par exemple, l'injection d'électrons se fait par la base du nanofil. Par « injection radiale », on entend ici que l'injection des trous dans la zone active est majoritairement réalisée par la surface latérale du nanofil. Par exemple, la zone d'injection de trous enrobe la zone active au moins partiellement sur une partie de sa hauteur.

En d'autres termes, le fait de prévoir l'injection axiale des électrons permet de libérer le cœur du nanofil pour la zone active qui représente alors l'essentiel du volume du nanofil. En effet, en raison de leur mobilité très élevée, les électrons occupent l'ensemble du volume de la zone active malgré la surface d'injection réduite.

Ensuite, puisque le dispositif est à base de nanofils, il est possible d'obtenir un bon confinement des porteurs de charges tout en limitant leur concentration, source du « Droop efficiency » par un choix approprié de la hauteur des nanofils, comme cela sera expliqué plus en détail par la suite.

Ensuite, les nanofils n'étant pas sensibles au paramètre de maille, le choix de la hauteur des nanofils, notamment pour obtenir une densité de courant appropriée sans « Droop efficiency », est décorellé du choix de la composition du semi-conducteur constitutif de la zone active, par exemple la composition en indium dans le cas d'un dispositif à base de GaN. Le choix de la longueur d'onde d'émission est ainsi plus large. Il est ainsi possible de fabriquer des LED à base de nanofils émettant dans le spectre visible, notamment du bleu au rouge dans le cas d'une LED à base de GaN, voire même de réaliser une LED émettant une lumière blanche en variant la composition en indium lors de l'épitaxie du cœur du nanofil.

Par ailleurs, la zone active représentant l'essentiel du volume du nanofil, le dispositif selon l'invention présente un rendement quantique interne amélioré même à forte densité de courant d'injection.

Selon un mode de réalisation, le nanofil de connexion comporte un cœur semi-conducteur du premier type dépourvu de coquille sur au moins une première et une deuxième portion formant respectivement la première et la deuxième région du nanofil de connexion. Notamment, la première portion du cœur du nanofil de connexion dépourvue de coquille comporte l'extrémité du nanofil opposée au support.

En d'autres termes, le nanofil de connexion est à l'origine un nanofil émetteur de lumière selon l'architecture « *core/shell* » qui a été « dénudé » de sa coquille à son extrémité opposée au support. On obtient alors un chemin électrique entre les différents nanofils formée d'une alternance de semi-conducteur du premier type et de semi-conducteur du second type, par exemple des alternances n-p-n-p. Les nanofils peuvent donc être fabriqués simultanément tout en garantissant un bon passage du courant entre ceux-ci.

Selon un mode de réalisation, le nanofil de connexion est constitué d'un matériau conducteur, permettant ainsi une connexion électrique de faible résistivité.

Selon un mode de réalisation, le support comporte une couche plane électriquement isolante sur laquelle est réalisé un contact conducteur plan formant la deuxième zone conductrice et sur lequel le nanofil de connexion et le deuxième nanofil sont formés.

Selon un mode de réalisation, les nanofils sont noyés dans une couche électriquement isolante et plane, les extrémités des nanofils opposées au support affleurant de ladite couche, et sur laquelle est réalisé un contact conducteur formant la première zone conductrice et enrobant les extrémités affleurantes du premier nanofil et du nanofil de connexion. Des techniques de fabrication planaire peuvent ainsi être mises en œuvre.

Selon un mode de réalisation, le dispositif comprend un réseau de nanofils émetteurs de lumière connectés en série par des connexions électriques en série.

Selon un mode de réalisation, le dispositif comprend un réseau de nanofils émetteurs de lumière constitué d'au moins deux ensembles de nanofils émetteurs de lumière connectés électriquement en parallèle, au moins un nanofils d'un ensemble étant connecté en série avec un nanofil de l'autre ensemble par une connexion électrique en série.

L'invention a également pour objet un procédé de fabrication d'un dispositif optoélectronique comportant au moins un premier et un deuxième nanofils émetteurs de lumière formés sur un support et comportant un cœur semi-conducteur, dont l'extrémité formée sur le support constitue l'une des zones parmi une zone d'injection de trous et une zone d'injection d'électrons, et une coquille semi-conductrice enrobant le cœur sur au moins une portion supérieure de celui-ci et constituant l'autre parmi la zone d'injection de trous et la zone d'injection d'électrons, ledit procédé consistant :

- à réaliser un support comportant une couche électrique isolante sur laquelle est formée un couche conductrice inférieure ;
- à réaliser sur le support trois nanofils émetteurs de lumière, identiques, comportant chacun un cœur semi-conducteur d'un premier type et une coquille semi-conductrice d'un second type enrobant le cœur sur au moins une portion supérieure de celui-ci, deux des nanofils étant réalisés sur le contact électrique ;
- à déposer une couche plane et électriquement isolante sur le support de manière à enrober les nanofils tout en laissant leurs extrémités libres affleurer de ladite couche ;
- à retirer une partie de la coquille sur l'extrémité libre de l'un des deux nanofils formés sur la couche conductrice inférieure de manière à libérer le cœur de celui-ci ; et
- à déposer un contact électrique supérieur sur la couche plane et isolante de manière à enrober l'extrémité libre du nanofil qui n'est pas réalisé sur la couche conductrice inférieure et l'extrémité libre du nanofil ayant subi le retrait d'une partie de sa coquille.

**BREVE DESCRIPTION DES FIGURES**

L'invention sera mieux comprise à la lecture de la description qui suit, donnée uniquement à titre d'exemple, et réalisée en relation avec les dessins annexés, dans lesquels des références identiques désignent des éléments identiques, et dans lesquels :

- la figure 1 est une vue en coupe schématique d'une nano-LED à multi-puits quantiques axiaux de l'état de la technique, tel que décrit dans le préambule ;
- la figure 2 est une vue en coupe schématique d'une nano-LED à multi-puits quantiques radiaux de l'état de la technique, tel que décrit dans le préambule ;
- la figure 3 est une vue schématique de dessus d'une matrice de nanofils connectés électriquement en parallèle et formant une LED, tel que décrit dans le préambule ;
- la figure 4 est une vue en coupe de la matrice de la figure 3 selon le plan A-A, tel que décrit dans le préambule ;
- la figure 5 est une vue en coupe schématique d'une connexion électrique en série de deux nano-LEDs (nanofils émetteurs de lumière) de type « *core/shell* » ;

- les figures 6a, 6b et 6c sont des vues schématiques en coupe de nanofils de connexion réalisés à partir de la nano-LED de la figure 2 ;
- les figures 7 et 8 sont respectivement des vues en coupe schématique d'une nano-LED à cœur actif et d'un nanofil de connexion obtenu à partir d'une telle nano-LED ;
- la figure 9 est un tracé de la densité de courant maximale de courant sans « *overflow* » dans la LED de la figure 7 ;
- la figure 10 est une vue en coupe schématique d'un mode de réalisation dans lequel les contacts d'alimentation électrique sont réalisés sur la même face d'un dispositif à nano-LEDs ;
- la figure 11 est une vue en coupe schématique d'un mode de réalisation dans lequel le support sur lequel sont formées les nanofils comporte une couche conductrice commune ;
- la figure 12 est une vue en coupe schématique d'un mode de réalisation dans lequel le support sur lequel sont formés les nanofils comporte une couche conductrice commune et dans lequel des nanofils sont formés directement sur cette couche ;
- la figure 13 est une vue en coupe schématique d'un mode de réalisation dans lequel les contacts supérieurs de la connexion série sont réalisés sur une partie importante de la hauteur des nanofils ;
- la figure 14 est une vue en coupe schématique d'un mode de réalisation dans lequel les contacts supérieurs de la connexion série ne recouvrent par la partie horizontale supérieure des nanofils ;
- la figure 15 est une vue en coupe schématique d'un mode de réalisation dans lequel les contacts supérieurs de la connexion série ne recouvrent pas la partie horizontale supérieure des nanofils et dans lesquels la partie horizontale de coquilles de nano-LED du type « *core/shell* » est ôtée ;
- les figures 16 à 22 sont des vues schématiques en coupe illustrant un procédé de fabrication d'une connexion série selon l'invention ;
- la figure 23 est une vue schématique en coupe d'une connexion série entre des nano-LEDs de la figure 1 ;
- les figures 24 et 25 sont des vues schématiques de dessus respectivement de contacts inférieurs et supérieurs d'une matrice de nano-LEDs connectées en série ; et
- les figures 26 et 27 sont des vues schématiques de dessus respectivement de contacts inférieurs et supérieurs de deux matrices de nano-LEDs connectées en série.

## DESCRIPTION DETAILLEE DE L'INVENTION

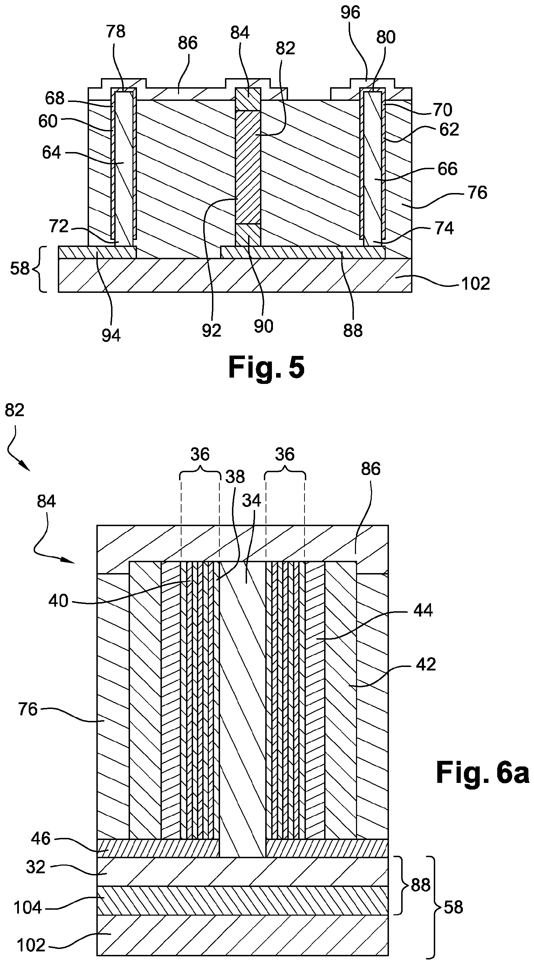

Il va à présent être décrit en relation avec la figure 5 une connexion électrique en série de l'invention pour connecter électriquement en série d'un premier et deuxième nanofils formant des nano-LEDs de type « *core/shell* » **60, 62** réalisés sur un support **58**.

De manière schématique, les nano-LEDs **60, 62** comprennent chacune :

- un cœur **64, 66** dans lequel se situe la zone active où se recombinent de manière au moins partiellement radiative les trous et les électrons ;
- une zone d'injection **68, 70** de porteurs de charge d'un premier type dans la zone active de recombinaison, par exemple une zone d'injection de trous, formant une coquille enrobant le cœur **64, 66** sur au moins une partie de la hauteur du cœur **64, 66;**
- une zone d'injection **72, 74** de porteurs de charge du second type dans la zone active de recombinaison, par exemple une zone d'injection d'électrons, comprenant au moins le pied de la nano-LED, c'est-à-dire l'extrémité de la nano-LED reposant sur le support **58.**

Dans le mode de réalisation illustré, les nano-LEDs sont noyées dans une couche planarisante électriquement isolante **76** formée sur le support **58,** sauf en ce qui concerne leurs extrémités **78, 80** opposées au support **58,** ci-après désignées « tête », qui émergent de la couche **76**.

La connexion électrique en série entre les nano-LEDs **60, 62** a pour fonction d'établir un chemin électrique entre la zone d'injection de trous **68** de la première nano-LED **60** et la zone d'injection d'électrons **74** de la deuxième nano-LEDs **62,** et comporte à cet effet :

- un nanofil de connexion **82,** formé sur le support **58** et noyé dans la couche **76** sauf en ce qui concerne sa tête **84** ;
- un premier contact **86** formé sur la couche **76**, connectant électriquement la tête **78** de la première nano-LEDs **60** avec la tête **84** du nanofil de connexion **82,** et électriquement isolé de la deuxième nano-LED **62;** et
- un deuxième contact **88** du support **58**, connectant électriquement le pied **90** du nanofil de connexion **82** avec le pied **74** de la deuxième nano-LEDs **62,** et électriquement isolé de la première nano-LED **60.**

La nature des nano-LEDS **60, 62** peut varier fortement, notamment en ce qui concerne la nature des matériaux et la structure des zones d'injection de trous **68, 70** et d'électrons **72, 74**. Le nanofil de connexion **82** est donc divisé fonctionnellement en au moins trois zones :

- une première zone comprenant la tête **84** du nanofil **82** qui est « électriquement compatible » avec la zone d'injection de trous **68** de la première nano-LED **60** ;
- une deuxième zone comprenant le pied **90** du nanofil **82** qui est « électriquement compatible » avec la zone d'injection d'électrons **74** de la deuxième nano-LED **62** ; et
- une troisième zone médiane **92** du nanofil de connexion **82** entre la tête **84** et le pied **90** qui permet le passage d'un courant entre les première et deuxième zones **82, 90**.

Par « électriquement compatible », on entend ici notamment le fait que la mise en série électrique des différentes zones en cause ne forme pas d'obstacle au passage du courant. Notamment, les nano-LEDs **60, 62** comprennent des zones semi-conductrices de types différents pouvant former des jonctions PN. De même, le nanofil de connexion **82** peut également comprendre un ou plusieurs matériaux semi-conducteurs, comme cela sera expliqué en détail ci-après. Ainsi donc, par exemple, la connexion électrique en série des nano-LEDs ne comprend pas de mise en série d'une jonction PN avec une jonction NP auquel cas il existe des diodes tête-bêche en série s'opposant au passage du courant.

La description précédente du nanofil de connexion **82** est schématique et fonctionnelle. Notamment, les zones du nanofil peuvent être réalisées en des matériaux différents ou deux zones, voire les trois zones, peuvent être formées dans le même matériau. De même, il a été décrit un agencement axial des trois zones du nanofil de connexion. Une ou plusieurs zones peuvent cependant être structurellement au moins partiellement radiales.

Sur la figure 5, sont également représentés des contacts inférieur **94** et supérieur **96** respectivement au contact du pied **72** de la première nano-LED **60** et de la tête **80** de la deuxième nano-LED **62** pour l'alimentation électrique des nano-LEDs. Comme illustré, une portion du contact inférieur **94** est libre pour permettre sa connexion à l'alimentation électrique. Dans la mesure où seulement deux nano-LEDs **60, 62** sont représentées, ces nano-LEDs font également office, dans cet exemple, de bornes d'entrée et de sortie de la connexion électrique en série. Bien entendu, plus de deux nano-LEDs peuvent être connectées en série selon le schéma décrit ci-dessus. Les contacts inférieur **94** et supérieur **96** sont alors par exemple associés respectivement aux deux nano-LEDs les plus extrêmes de cette connexion en série. Le contact inférieur **94** est avantageusement, mais non obligatoirement, de même nature que le deuxième contact **88** connectant électriquement la deuxième nano-LED **62** avec le nanofil de connexion **82**. De même, le contact supérieur **96** est avantageusement, mais non obligatoirement, de même nature que le première contact **86** connectant électriquement le nanofil de connexion **82** avec la première nano-LED **60**.

La couche **76** a pour fonction d'offrir une surface isolante sur laquelle former des contacts de connexion électrique entre les têtes des nanofils. Bien entendu, tout autre moyen offrant cette fonction est approprié dans le cadre de l'invention.

Il va à présent être décrit plusieurs modes de réalisation de l'invention, étant entendu que les caractéristiques relatives aux nanofils de connexion décrites dans un mode de réalisation peuvent être combinées avec les caractéristiques du support d'un autre mode de réalisation. De même, les caractéristiques des contacts d'alimentation décrites dans un mode de réalisation peuvent s'appliquée et/ou se substituer aux caractéristiques de contacts d'alimentation d'un autre mode de réalisation.

Selon un premier mode de réalisation, le nanofil de connexion **82** est réalisé dans un matériau électriquement conducteur. Par exemple, le nanofil de connexion **82** est métallique, ce qui permet d'obtenir à la fois une connexion de grande qualité et une parfaite compatibilité avec n'importe quel type de nano-LED, quelques que soient les matériaux et la structure des zones d'injection de trous et d'électrons.

Ceci présente cependant le désavantage de complexifier le processus de fabrication d'une matrice de nano-LEDs puisqu'il faut prévoir deux types de processus de fabrication, l'une pour les nano-LEDs et l'autre pour les nanofils de connexion.

Selon un second mode de réalisation, le nanofil de connexion est une nano-LED qui a été ensuite modifiée pour remplir la fonction de nanofils de connexion. Ceci permet de fabriquer l'ensemble des nanofils, nano-LEDs et nanofils de connexion, lors d'un même processus de croissance.

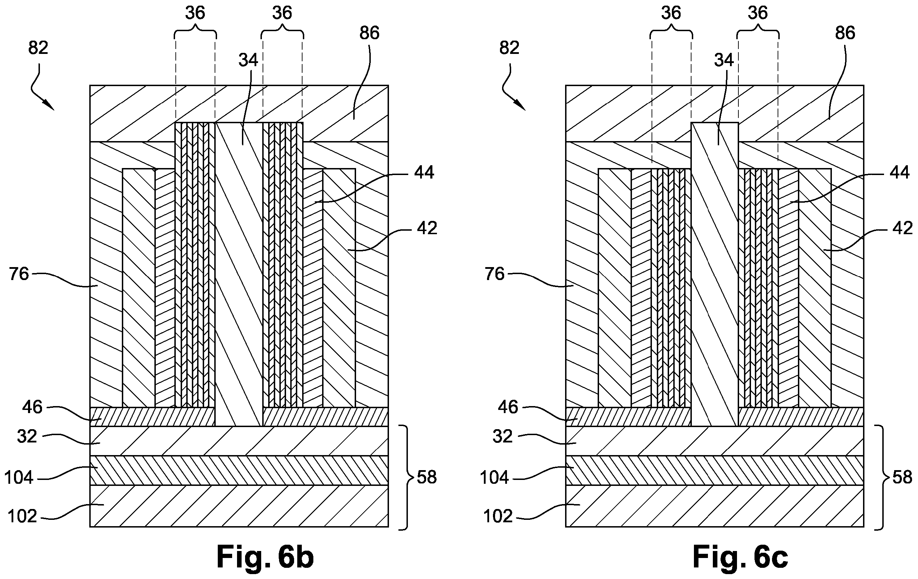

Une application du second mode de réalisation aux nano-LEDs « *core/shell* » de la figure 2 est à présent décrite en relation avec les figures 6a, 6b et 6c.

Une nano-LED **30** est donc modifiée de manière à ôter une partie de la coquille **42** sur la tête **84** de celle-ci, et notamment au moins la portion de coquille **42** recouvrant la face supérieure **100** du cœur **34** de la nano-LED. Ceci libère donc le cœur **34**, qui est électriquement compatible avec la coquille **42** formant zone d'injection de trous des nano-LEDs **60, 62**, et qui est recouvert par la première zone **86** de la connexion série, par exemple un contact **86** métallique.

Dans l'exemple illustré à la figure 6a, le sommet de la nano-LED **30** a été ôté de manière à libérer le cœur **34** tout en laissant en contact la zone active **36**, ainsi que les volumes **42** et **44**, avec la zone conductrice **86**.

Dans l'exemple illustré à la figure 6b, le sommet de la nano-LED **30** a été ôté ainsi que les volumes **42** et **44** sur une partie de la hauteur de la nano-LED **30**, tout en laissant en contact la zone active **36** avec la zone conductrice **86**.

Dans l'exemple illustré à la figure 6c, le sommet de la nano-LED **30** a été ôté ainsi que la zone active **36** et les volumes **42** et **44** sur une partie de la hauteur de la nano-LED **30,** mais en évitant le contact de la zone active **36** avec la zone conductrice **86.**

Le support **58** comprend par exemple un substrat commun isolant **102** et le deuxième contact **88** de la connexion série est par exemple constitué d'une couche électriquement conductrice, notamment métallique, ou une couche semi-conductrice fortement dopée de même type que le cœur **34,** déposée sur le substrat isolant **102.**

En variante, le deuxième contact **88** comporte une première couche conductrice d'électricité **104,** métallique ou semi-conductrice fortement dopée, déposée sur le substrat isolant **102,** et une deuxième couche semi-conductrice **32,** par exemple analogue à celle de l'état de la technique sur laquelle sont formées les nano-LEDs. Enfin, la couche isolante et planarisante **76** est par exemple constituée du même matériau que la couche isolante **46.**

De préférence, toutes les nano-LEDs sont réalisées sur des portions de support **58** de ce type.

Afin d'augmenter l'émission de lumière et diminuer l'absorption par le substrat **102,** la couche métallique entrant dans la constitution du deuxième contact **88** est de préférence réalisée en un métal réfléchissant la longueur d'onde d'émission, par exemple de l'aluminium ou de l'argent. De même, la couche métallique du contact **88** recouvre avantageusement sensiblement toute la surface du substrat commun **102,** la couche métallique étant par exemple déposée pleine plaque sur le substrat **102,** puis gravée pour isoler le nanofil de connexion **82** de la première nano-LED **60.** Si le matériau de la couche métallique est au contraire choisi dans un métal absorbant la longueur d'onde émise par les nano-LEDs, par exemple pour les besoins de l'application ou en raison de contraintes de fabrication, la surface du deuxième contact **88** est alors choisie la plus faible possible.

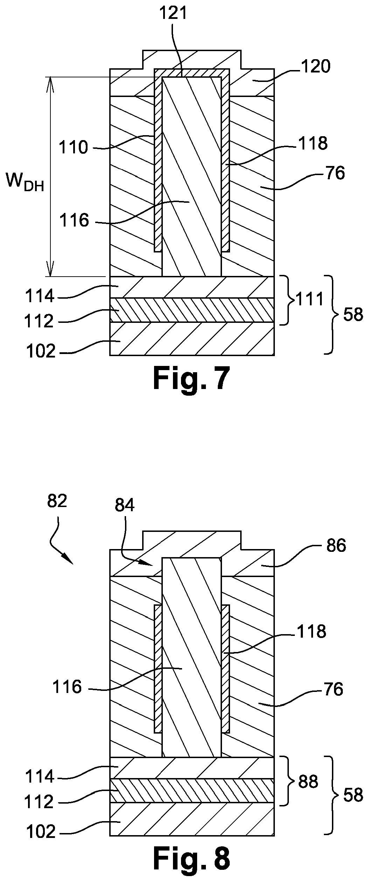

Une application du second mode de réalisation aux nano-LEDs « *core/shell* » de la figure 7 est à présent décrit en relation avec la figure 8. On notera que des nano-LEDs représentées à la figure 7 peuvent être connectées en parallèle, par exemple selon le schéma de connexion décrit aux figures 3 et 4.

En se référant à la figure 7, une nano-LED **110** est formée sur une portion du support **58** comprenant un substrat isolant **102** commun sur lequel est déposée une couche conductrice d'électricité **111,** par exemple métallique ou semi-conductrice dopée. En variante, la couche **111** comporte une première couche conductrice d'électricité **112** déposée sur le substrat **102** et sur laquelle est formée une couche de GaN de type n **114.** La portion de support **58** est par exemple constituée d'un métal décrit ci-dessus en relation avec la figure 6 ou d'un semi-conducteur dopé.

La nano-LED **110** comporte un cœur **116** réalisé en matériau semi-conducteur de la famille III-V ou II-VI, préférentiellement de la famille III-N. Le cœur **116** est enrobé au moins sur sa partie supérieure par une coquille **118** réalisée en matériau semi-conducteur dopé p de la même famille que celle du matériau du cœur **116,** mais présentant un gap d'énergie supérieur de manière à permettre l'injection de trous depuis la coquille **118** vers le cœur **116.** La coquille **118** est de préférence isolée du support **58** afin d'éviter tout court circuit entre le contact électrique supérieur **120** et la couche conductrice inférieure **111.** Par exemple, la coquille **118** s'arrête au dessus du support **58.** Enfin, la nano-LED **110** est noyée dans une couche isolante et planarisante **76,** sauf en ce qui concerne sa tête, et un contact électrique supérieur **120** formé sur la couche **76,** par exemple la zone **86** de la connexion électrique.

La nano-LED **110** fonctionne de la manière suivante. Des électrons sont injectés dans le cœur **116** via la couche conductrice **111** du support **58** et des trous sont injectés dans la coquille **118** via le contact **120.** Les paires électrons-trous injectés se recombinent donc, au moins partiellement de manière radiative, dans le cœur **116** qui constitue une zone active.

On notera que le fait que l'injection des électrons soit réalisée axialement, dans l'exemple par la base du nanofil, n'est pas restrictif du point de vue de l'injection électrique en raison de la grande mobilité des électrons. En outre, tout point du cœur **116,** c'est-à-dire de la zone active, se trouve à une distance inférieure ou égale au rayon du cœur. La surface d'injection des trous est donc à la fois très grande et très proche de chaque point de la zone active.

Dans le cas où la couche **111** comporte une couche semi-conductrice, cette couche est avantageusement sélectionnée de manière à présenter une résistivité faible, notamment de l'ordre de 0,001 ohm/cm, afin de faciliter l'injection d'électrons dans le cœur **116,** et est par exemple constituée de GaN dopé n+ d'une épaisseur de 400 nanomètres. Une telle couche peut d'autre part supporter l'épitaxie des nanofils de GaN.

Par ailleurs, tout type de matériau semi-conducteur pouvant être modulé en énergie et épitaxié sous forme de nanofils peut entrer dans la constitution du cœur **116** et de la coquille **118.** Par exemple, la nano-LED **110** est réalisée à base de GaN : le cœur **116** est constitué de InGaN non intentionnellement dopé, et comportant un dopage n résiduel inférieur à $10^{16}$ électrons/cm$^3$, dont la composition en indium est choisie en fonction de la longueur d'onde à émettre par la nano-LED **110.** La coquille **118** est constituée de GaN dopé p par du magnésium, ou de InGaN dopé p par du magnésium de composition en indium inférieure à celle du cœur **116,** le matériau de la coquille **118** présentant une concentration de porteurs p de l'ordre de $10^{18}$ trous/cm$^3$.

En variante, la nano-LED **110** est réalisée à base de ZnO : le cœur **116** est constitué de ZnO et la coquille **118** dopée p est constituée de ZnMgO, ou bien le cœur **116** est constitué de ZnCdO et la coquille **118** est constituée de ZnO.

En variante encore, la nano-LED **110** est réalisée à base de GaAlAs, le cœur **116** est constitué de GaAs et la coquille **118** dopée p est constituée de GaAlAs, ou bien le cœur **116** est constitué de InGaAs et la coquille **118** est constituée de GaAs.

Selon encore une autre variante, la nano-LED **110** est réalisée à base de AlInGaP, le cœur **116** est constitué de AlGaInP et la coquille **118** est constituée du même matériau mais avec une composition plus forte en aluminium.

Le contact électrique supérieur **120** est semi-transparent à la longueur d'onde d'émission de la nano-LED et peut être constitué de différents empilements, comme par exemple un contact semi-transparent constitué de fines couches de Ni et d'Au, ou bien en oxyde d'indium-étain (ou ITO pour « *Indium Tin Oxyde* »). Il peut être recouvert localement d'un peigne épais, par exemple des couches plus épaisses de Ni et d'Au pour diminuer sa résistance série.

Grâce à son architecture en nanofil, réalisable quel que soit le type de matériau semi-conducteur choisi en raison du peu d'influence du paramètre de maille, il existe un large choix quant à la longueur d'onde émise par la LED.

On notera également que la nano-LED **110** présente une structure du type à double hétéro-structure puisqu'il existe une première hétéro-structure formée du cœur **116** et de la surface du support **58** conductrice ou semi-conductrice, et une seconde hétéro-structure formée du cœur **116** et de la coquille **118.**

Des nano-LEDs **110** peuvent être connectées électriquement en série en utilisant comme nanofil de connexion **82** une nano-LED **110** modifiée, comme illustrée à la figure 8. Une nano-LED **110** est modifiée de manière à ôter une partie de la coquille **118** sur la tête **84** de celle-ci, et notamment au moins la portion de coquille **118** recouvrant la face supérieure **121** du cœur **116** de la nano-LED. Ceci libère donc le cœur **116,** qui est électriquement compatible avec la coquille **118** formant zone d'injection de trous des nano-LEDs **110.** Les première et deuxième zones **86, 88** de la connexion série sont respectivement les zones **120** et **111** décrites en relation avec la figure 7.

Par rapport aux nano-LED classiques, telles que décrites par exemple en relation avec les figures 1 et 2, les nano-LED **110** ne nécessitent pas de zone EBL. Cette zone est usuellement nécessaire pour confiner les porteurs dans les structures à multi-puits quantiques, telles que décrites aux figures 1 et 2 par exemple. Or, une croissance parfaitement contrôlée à la fois en termes de morphologie, de composition, d'épaisseur et de dopage des semi-conducteurs III-N ternaires d'une zone EBL (AlGaN) est indispensable pour éviter de bloquer les trous injectés, et donc de rendre une nano-LED efficace. En outre, la nano-LED **110** présente, comparativement aux nano-LEDs à multi-puits quantiques, une zone active de recombinaison beaucoup plus importante par rapport au volume total du nanofil, ce qui implique une efficacité quantique interne augmentée. Ensuite, puisque la zone active d'une nano-LED **110** ne présente pas de puits quantiques, la densité de courant applicable à la nano-LED avant une diminution sensible de son efficacité (phénomène connu sous le nom de « *Droop Efficiency* ») est plus importante.

En prenant par exemple le cas d'une matrice de nano-LEDs **110** connectées en série, et en faisant l'hypothèse de nano-LEDs **110** cylindriques, le facteur de remplissage F, égal au ratio entre l'aire totale des bases des nano-LEDs **110** sur l'aire du support **58,** peut être calculé selon la relation :

$$F = \frac{\pi}{4}.d^2.d_n$$

où :

- d est le diamètre des nano-LEDs **110** ; et
- $d_n$ est la densité surfacique des nano-LEDs **110,** exprimée en nombre de nanofils par cm$^2$.

En fixant le diamètre d des nanofils à 100 nm et leur densité à 4.10$^9$cm$^{-2}$, le facteur F est alors égal à 0,314. Ce facteur F permet de pondérer la densité de courant macroscopique afin de prendre en compte la différence entre l'aire du dispositif et la somme des aires de la base des nanofils.

En raison du peu d'influence du paramètre de maille, il est possible de vérifier que la hauteur de la zone active **116** des nano-LEDs **110** en fonction de la densité de courant souhaitée $J_{overflow}$ soit suffisante pour éviter tout phénomène d' « *overflow* » (ou phénomène de « *débordement* »).

Plus particulièrement, pour des cœurs **116** des nano-LEDs **110** constitués d'un matériau semi-conducteur supposé dégénéré tel que $\dfrac{E_F - E_C}{k.T} \geq 5$, c'est à dire sous forte injection électrique, dont la hauteur est $W_{DH}$ (i.e. la hauteur de la zone active **116),** la valeur minimale $J_{overflow}$ de la densité de courant avant d'obtenir une saturation des états dans la zone active (ou courant de « débordement », tout courant supplémentaire ne générant pas de recombinaisons radiatives dans la zone active) est obtenue selon la relation:

$$F.J_{overflow} = \left(\frac{4.N_C}{3.\sqrt{\pi}}\right)^2 . \left(\frac{E_F - E_C}{k.T}\right)^3 .e.B.W_{DH}$$

où :

- F est le facteur de remplissage des nano-LEDs **110** ;
- $N_C$ est la densité effective d'états de conduction dans la bande de conduction du matériau du cœur **116** des nano-LEDs **110** ;
- $E_F$ et $E_C$ sont respectivement les niveaux d'énergie de Fermi et de conduction du matériau du cœur **116** des nano-LEDs **110** ;
- k est la constante de Boltzmann ;
- T est la température de jonction (température de la zone active) du cœur **116** des nano-LEDs **110** ;
- e est la charge élémentaire ; et
- B est le coefficient de recombinaison bimoléculaire du matériau du cœur **116** des nano-LEDs **110** .

Une hauteur minimale $W_{DH}$ des cœurs **116** des nano-LEDs **110** sélectionnée de cette manière a pour effet que lorsqu'une densité de courant $J_{overflow}$ est injectée dans les nano-LEDs **110**, le niveau de Fermi de la double hétéro-structure atteint le sommet de la barrière d'énergie séparant les niveaux d'énergie $E_F$ et $E_C$. La densité des porteurs de charge dans les cœurs **116** est alors maximale, toute augmentation supplémentaire de la densité de courant n'entrainant pas d'augmentation de la densité des porteurs de charge, puisque ces derniers s'échappent des cœurs **116** sans se recombiner. En d'autres termes, pour toute valeur de densité de courant inférieure ou égale à $J_{overflow}$, les porteurs ne s'échappent pas des cœurs **116**, de sorte que le phénomène de « *Droop Efficiency* » est diminué.

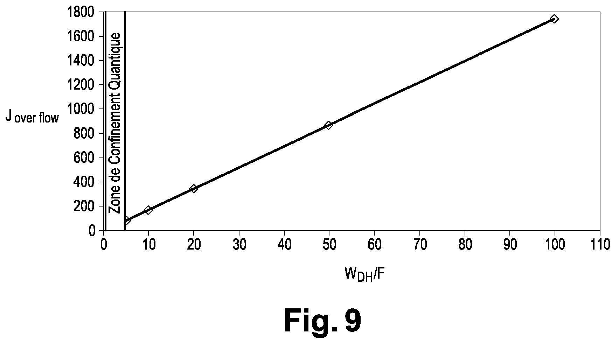

La figure 9 est un tracé de la valeur $J_{overflow}$ en fonction du ratio $\dfrac{W_{DH}}{F}$ pour des nano-LED **110** en InGaN avec une composition en indium de 15%, pour lequel :

- $Nc = 10^{18}$ cm$^{-3}$ ;
- $E_F$ - $E_C$ = 150 meV ;
- $B = 10^{-11}$ cm$^3$.s$^{-1}$;
- et T est la température de jonction.

Il est intéressant de noter que la valeur $J_{overflow}$ est directement proportionnelle au ratio $\dfrac{W_{DH}}{F}$ , et donc à l'épaisseur de la zone active, c'est-à-dire la hauteur $W_{DH}$ des cœurs **116**, pour un facteur de remplissage F donné. Ceci est vrai dans le cas de non confinement quantique, c'est-à-dire pour un ratio $\dfrac{W_{DH}}{F}$ supérieur à 5 nm. Dans le cas des puits quantiques, la quantification des niveaux d'énergie rend encore plus critique l'augmentation de la densité de courant sur l'échappement des porteurs.

Compte tenu des densités de courant de fonctionnement souhaitées actuellement pour les LEDs, typiquement des densités supérieures ou égales à 200 A/cm$^2$, on peut fixer le ratio $\dfrac{W_{DH}}{F}$ minimum à 15nm sans avoir une chute importante du rendement quantique interne des nano-LEDs **110.**

Par ailleurs, afin d'assurer son rôle de structure de confinement de manière efficace, la hauteur maximale des cœurs **116** est choisie inférieure à la longueur de diffusion des porteurs. Une hauteur maximale des cœurs **116** de quelques microns permet d'obtenir un confinement efficace.

Des cœurs **116** de nano-LEDs **110** dont la hauteur minimale est de 40 nm, et dont la hauteur maximale n'excède pas quelques micromètres permettent donc à la fois d'assurer un bon confinement des porteurs de charge tout en évitant la chute du rendement quantique interne en raison des pertes par échappement des porteurs hors de la zone active.

Plus particulièrement, pour les nanofils en InGaN précédemment décrits, une densité de courant supérieure ou égale à 200 A/cm$^2$ avant le « *Droop Efficiency* » est obtenue.

Plus généralement, cette caractéristique est atteinte pour des cœurs de nano-LED en InGaN, ayant un ratio

$$\frac{W_{DH}}{F}$$ supérieur à 5 nm, ou ayant:

- une densité de surface $d_n$ comprise entre $10^6$ et $10^{10}$, par exemple une densité de $4.10^9 cm^{-2}$
- les cœurs **116** ont un diamètre d compris entre 50 nanomètres et quelques micromètres, par exemple un diamètre de 100 nanomètres ; et
- la hauteur de la zone active des nanofils est comprise entre 40 nanomètres et une dizaine de micromètres

Comme dit précédemment, la structure des nano-LEDs **110** présente un volume actif plus élevé que les nano-LEDs classiques, comme par exemple celles illustrées aux figures 1 et 2. Cette propriété génère à la fois une augmentation du rendement quantique interne en raison de la plus grande quantité de matériau actif, ainsi qu'une diminution du « *Droop Efficicency* ». En effet, ce phénomène étant lié en partie à l'effet Auger, comme la densité de porteurs dans la zone active est inversement proportionnelle au volume de la zone active et que l'effet Auger varie comme le cube de cette même densité, alors un volume de zone active plus important implique une forte baisse des recombinaisons non-radiatives associées et donc une augmentation du rendement radiatif.

Par exemple, en comparant une matrice de nano-LEDs **110** avec une matrice de nano-LEDs **10** à base de nanofils à multi-puits quantiques axiaux décrite à la figure 1, et en fixant un même diamètre de nanofils pour ces nano-LEDs, une même densité surfacique et un même schéma de connexion (par exemple les nano-LEDs sont connectées en série), le rapport du volume $V_1$ de la zone active dans la LED **110** sur le volume $V_2$ de la zone active dans la LED **10** est égal à :

$$\frac{V_1}{V_2} = \frac{W_{DH}}{nW_{QW}}$$

où :

- n est le nombre de puits quantiques dans la nano-LED **10,** et
- $W_{QW}$ est la dimension axiale des multi-puits quantiques au sein de la zone active **16.**

Le tableau 1 ci-dessous détaille la valeur du rapport $V_1/V_2$ dans différentes configurations :

- LED **110** dont la zone active a une hauteur $W_{DH}$ de $1\mu m$ ou de 100 nm ; et
- LED **10** contenant 5 puits quantiques pour une épaisseur $W_{QW}$ égale à 2,5 nm.

Le tableau 1 détaille également plusieurs rapports $V_1/V_2$ selon plusieurs hypothèses concernant le fonctionnement réel de la nano-LED **10** à multi-puits quantiques, à savoir :

- hypothèse 1 : les recombinaisons radiatives des paires électrons-trous se produisent dans la totalité du volume de la zone active **16** des nanofils ;
- hypothèse 2 : l'épaisseur de la zone dans laquelle les recombinaisons radiatives ont lieu ne dépasse pas 1nm, pour 2,5 nm d'épaisseur réelle. Cette hypothèse repose sur les résultats de la publication N.F. Gardner et al., « Blue-emitting InGaN-GaN double-heterostructure light-emitting diodes reaching maximum quantum efficiency above 200 A/cm2 », Applied Physics Letters 91, 243506 (2007), qui démontrent cette réduction de l'épaisseur effective de la zone active en raison de la présence d'intenses champs piézoélectriques internes ; et
- hypothèse 3 : les recombinaisons radiatives ont lieu uniquement dans le puits quantique situé le plus proche de la zone d'injection de trous **22,** comme cela est le cas des structures LEDs planaires à multi-puits quantiques InGaN/GaN.

**Tableau 1**

| | Hypothèse 1 : | Hypothèse 2 : | Hypothèse 3 : |
|---|---|---|---|
| $W_{DH}$ = $1\mu m$ $W_{SQ}$ = 2,5 nm | 80 | 200 | 1000 |
| $W_{DH}$ = 100nm | 8 | 20 | 100 |

(suite)

| | Hypothèse 1 : | Hypothèse 2 : | Hypothèse 3 : |
|---|---|---|---|
| $W_{SQ}$ = 2,5 *nm* | | | |

Il apparaît donc clairement à la vue de ce tableau que le volume de matériau actif est largement augmenté dans la nano-LED **110,** de 8 à 1000 fois selon l'hypothèse retenue. Par conséquent, le rendement quantique interne d'une LED à base de nano-LEDs **110** est grandement amélioré par rapport une LED à base de nanofils à multi-puits quantiques axiaux **10.**

De même, en comparant une matrice de nano-LEDs **110** à une matrice de nano-LEDs **30** à base de nanofils à multi-puits quantiques radiaux décrite à la figure 2, et fixant le diamètre hors zone d'injection de trous identique pour les deux nano-LEDs, ainsi que leur densité surfacique en nanofils et schéma de connexion, le rapport du volume $V_1$ de la zone active dans la matrice de nano-LEDs **110** sur le volume $V_3$ de la zone active dans la matrice de nano-LEDs **30** est égal à :

$$\frac{V_1}{V_3} = \frac{\pi . R_1^{\,2} . L_1}{2 . \pi . R_3 . L_3 . n . W_{QW}}$$

où :

- $R_1$ est le rayon du cœur **116** des nano-LEDs **110** ;
- $L_1 = W_{DH}$ est la longueur du cœur **116** de la nano-LED **110** ;
- $R_3$ est le rayon sans les volumes **42 et 44** des nanoLEDs **30;**
- $L_3$ est la hauteur des nano-LEDs **30** ;
- $W_{QW}$ est l'épaisseur des multi-puits quantiques des nano-LEDs **30,** c'est-à-dire l'épaisseur du cylindre formé par une couche d'InGaN **40** de la zone active **36** des nano-LEDs **30** ; et
- N est le nombre de puits quantiques des nano-LEDs **30.**

Le tableau 2 détaille différents rapports $V_1/V_3$ pour $R_1 = R_3 = R$ = 50nm, L1 = L3, n = 5 et $W_{QW}$ = 2,5 nm, ainsi que pour les hypothèses quant au fonctionnement réel de la nano-LED **30** telles que précédemment décrites.

**Tableau 2**

| | Hypothèse 1 : | Hypothèse 2 : | Hypothèse 3 : |
|---|---|---|---|
| *R* = 50*nm* | **2** | **5** | **25** |

Là encore, on observe une augmentation sensible du gain en volume, et donc du gain en rendement quantique interne d'une LED à base de nano-LEDs **110** par rapport à une LED à base de nano-LEDs **30.**

On notera que le gain de volume actif de la structure de la nano-LED **110** permet même à une matrice de nano-LEDs **110** connectées en série de présenter un volume actif égal ou supérieur au volume d'une matrice de nano-LEDs **10** ou **30** connectées en parallèle. Ainsi par exemple, dans le pire des cas, le volume actif d'une matrice de nano-LEDs **110** connectées en série est égal au volume actif d'une matrice de nano-LEDs **30** connectées en parallèle, les rapports présentés au sein des tableaux 1 et 2 étant divisés par deux du fait qu'une nano-LEDs **110** représente un nanofil sur deux dans une connexion série par rapport à une connexion en parallèle.

De même, on notera qu'il est possible de compenser la perte de densité de nano-LEDs en raison de la présence des nanofils de connexion **82.** Par exemple, en supposant une matrice de nano-LEDs **30** connectées en série, de densité D, de hauteur de cœur L3 et de rayon R contenant une zone active radiale constituée de n puits quantiques d'épaisseur $W_{QW}$. En parallèle, en considérant le cas d'une LED planaire, et sans perte de densité surfacique, constituée d'une zone active équivalente, c'est-à-dire n puits quantiques d'épaisseur e = $W_{QW}$, le rapport entre le volume actif dans une matrice de nano-LEDs **30** et le volume actif dans la structure planaire pour une surface de support **58** fixée S est donné par la formule suivante :

$$\frac{2\pi \times R \times L3 \times n \times W_{QW} \times D \times S}{n \times e \times S} = 2\pi \times R \times L3 \times D$$

Ainsi donc, la condition pour que le volume actif dans matrice de nano-LEDs **30** soit supérieur au volume actif de la structure planaire est donc donnée par :

$$L3 > \frac{1}{2 \times \pi \times D \times R}$$

Par exemple, une densité réalisable de nanofils (nano-LEDs **30** et nanofils de connexion **82)** est de l'ordre de $1.10^7$ fils/cm$^2$, ce qui revient à une densité effective de nano-LEDs **30** de D = $5.10^6$ fils/cm$^2$, car un fil sur deux seulement participera à l'émission de lumière. En supposant un rayon moyen d'une nano-LED **30** d'environ 1 $\mu$m, une hauteur de cœur L3 supérieure à 3 $\mu$m est suffisante pour satisfaire la condition précédente, sachant par ailleurs qu'il est aujourd'hui possible de fabriquer des nano-LEDs ayant une hauteur de cœur moyenne de 10 $\mu$m.

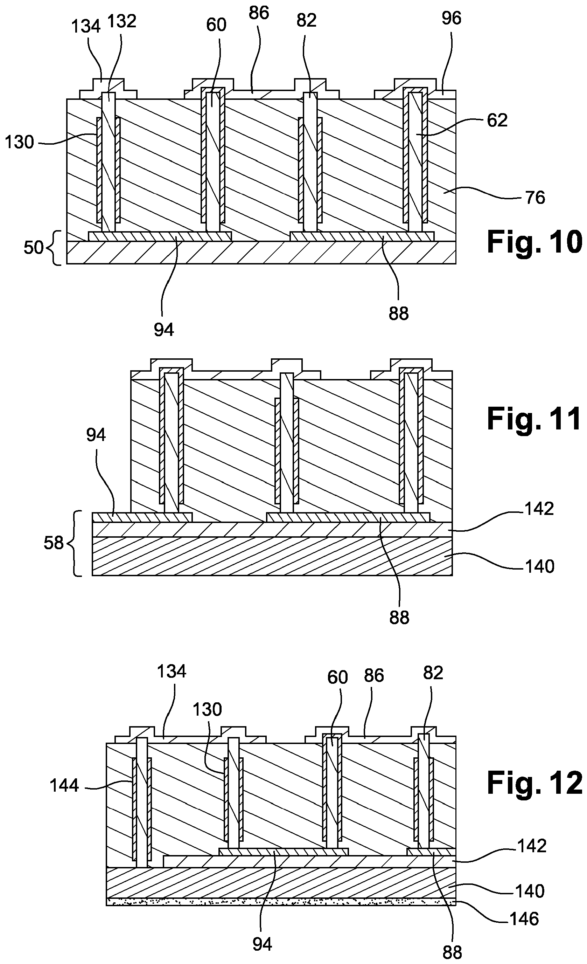

Il va à présent être décrit en relation avec les figures 10 à 15 d'autres formes de réalisation de l'invention. Bien que ces formes de réalisation soient décrites en relation avec les nano-LEDs **110,** on comprendra que ces formes de réalisation s'appliquent également à d'autres types de nano-LEDs, par exemple celles décrites aux figures 1 et 2.

La figure 10 illustre un mode de réalisation dans lequel les contacts d'alimentation sont disposés sur la même face du dispositif. Ce mode de réalisation diffère de celui décrit en relation avec la figure 5 en ce qu'il y a un nanofil de connexion supplémentaire **130,** par exemple identique au nanofil de connexion **82,** agencé sur le contact inférieur **94,** par exemple identique au contact inférieur **88,** et dont la tête **132** est connectée à un deuxième contact supérieur **134.** L'alimentation électrique de l'ensemble est ainsi réalisée par deux contacts supérieurs **96** et **134.**

La figure 11 illustre un mode de réalisation dans lequel le support **58** comporte une première couche conductrice, en silicium par exemple, recouverte d'une couche isolante **142,** en AlN, SiN$_x$ ou SiO$_2$ par exemple, sur laquelle sont formées les contacts **88, 94.** Ce mode de réalisation permet ainsi l'utilisation d'un substrat en silicium ou un substrat métallique, c'est-à-dire un substrat bas coût et de large surface par rapport au substrat isolant, notamment en saphir, tel qu'utilisé dans les modes de réalisation précédents. On notera que le caractère conducteur du substrat n'est pas ici utilisé.

La figure 12 illustre un mode de réalisation dans lequel les contacts d'alimentation sont pris de part et d'autre de la structure. Par exemple, une surface de la couche conductrice **140** de la figure 12 est libre et un nanofil **144,** dans l'exemple illustré un nanofil de connexion, est formé sur la couche **140** et a sa tête au contact d'un contact supérieur **134.** Un contact d'alimentation inférieur **146** est en outre prévu sur la face inférieure de la couche **140.** Tout d'abord, ce mode de réalisation présente également l'avantage d'utilisé un substrat conducteur, par exemple du Si ou un substrat métallique, bas coût et de large surface. En outre, le caractère conducteur du substrat est utilisé grâce :

- au nanofil de connexion **144** épitaxié directement sur le substrat conducteur **140** ;
- et au contact **146** en face arrière du substrat **140.**

Ainsi, les contacts d'alimentation sont disposés de part et d'autre de la structure **82, 146.** L'avantage est de ne pas avoir à dégager un contact inférieur **94** tel que par exemple illustré à la figure 11 au niveau des nanofils.

Les modes de réalisation suivants permettent une extraction de lumière améliorée.

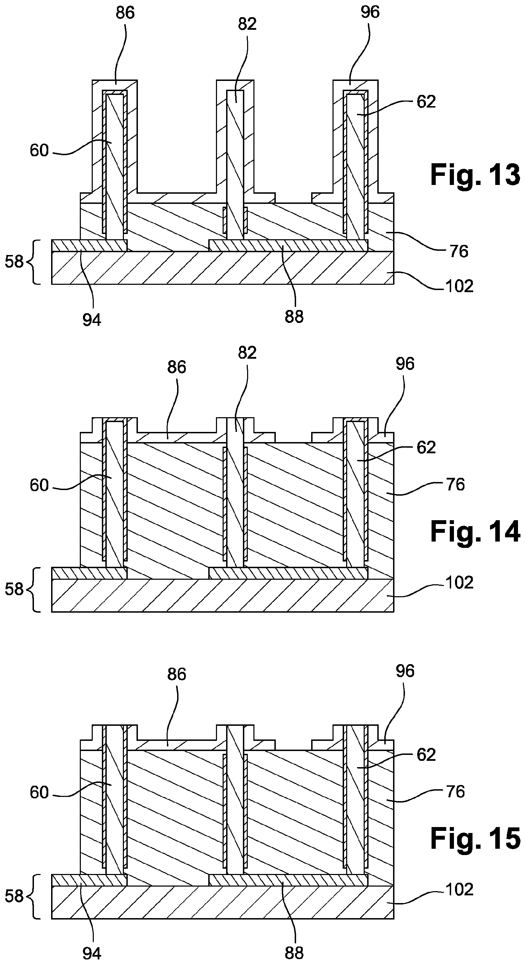

Sur la figure 13, la couche isolante et planarisante **76** n'est réalisée que sur une faible partie de la hauteur des nano-LEDs **60, 62** et les nanofils de connexion **82.** Ainsi, l'indice effectif de réfraction moyen de l'ensemble de la structure est diminué, puisque les nanofils sont à présent entourés d'air, d'indice de réfraction inférieur à celui de la couche planarisante **76,** permettant ainsi une meilleure extraction de la lumière. Un second avantage de ce mode de réalisation réside dans l'augmentation de la surface de contact entre la coquille des nano-LEDs **60, 62** et les contacts supérieurs **86, 96.** L'efficacité d'injection des trous est améliorée. On notera que ce type de contact réalisé sur une grande partie des nano-LEDs peut également être utilisé dans le cadre d'une connexion en parallèle.

Sur la figure 14, la partie horizontale des contacts supérieurs **86, 96** qui recouvre le sommet des nano-LEDs **60, 62** est retirée afin d'éviter l'absorption de la lumière guidée au sommet desdites nano-LEDs **60, 62.** De même, ou de manière optionnelle, la partie horizontale du contact **86** est ôtée du nanofil de connexion **82.**

Comme illustré à la figure 15, il est également possible de retirer la partie supérieure de la coquille **118** des nano-LEDs **60, 62** tant que le cœur **116** de celles-ci n'est pas en contact direct avec le contact **86, 96.**

En outre, concernant les nano-LEDs de type « *core/shell* » à multi-puits quantiques présentant à la fois des puits radiaux (verticaux) sur les flancs des fils et également des puits axiaux (horizontaux) au sommet des fils, ces puits quantiques ont donc des orientations de croissance différentes, ce qui influe grandement sur leurs propriétés optiques (différentes composition en In par exemple, différentes épaisseurs, etc...). En particulier, les champs piézoélectriques qui sont présents uniquement dans les puits axiaux limitent grandement leur efficacité. En retirant la portion horizontale du contact **86** supérieur, ces puits axiaux ne seront pas traversés par le courant électrique. Ainsi, seuls les puits radiaux seront efficacement excités, ce qui permet d'améliorer l'efficacité et l'homogénéité d'émission des dispositifs.

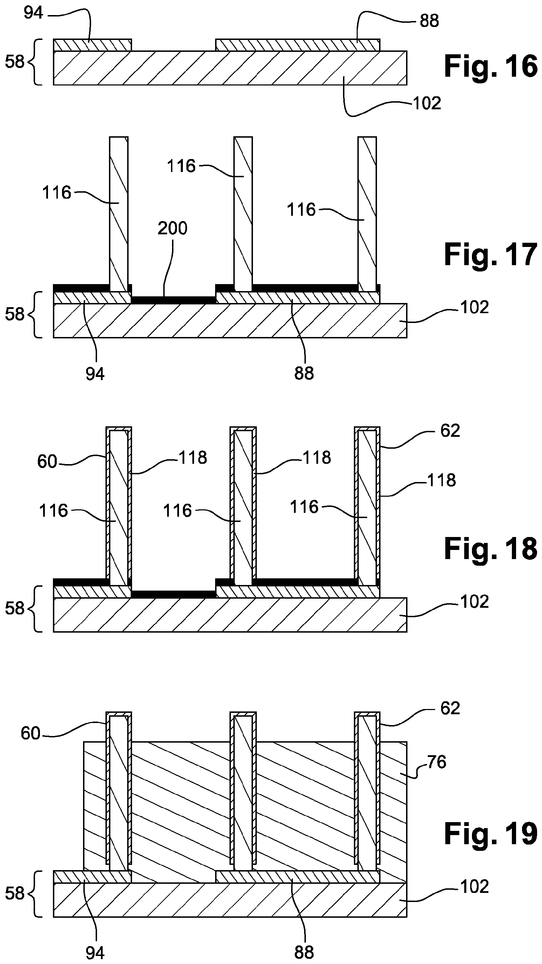

Il va à présent être décrit en relation avec les figures 16 à 22 un procédé de fabrication de nano-LEDs de type « *core/shell* » **60, 62** connectées en série par un nanofil de connexion **82.**

Le procédé débute par la réalisation du support **58** avec les différents contacts d'alimentation **94** et les contacts de la connexion série **88** (figure 16). Par exemple, on réalise le dépôt de zones conductrices métalliques ou en semi-conducteur dopé **88, 94** sur un substrat électriquement isolant **102,** par exemple un substrat en Saphir 2 pouces. Par exemple, une couche de GaN dopé n de 400nm d'épaisseur est épitaxiée sur toute la surface du substrat **102,** puis une étape de lithographie (optique ou électronique) est mise en œuvre pour graver localement cette couche afin de former une alternance de zones localisées isolantes et conductrices. Une technologie planaire est ainsi utilisée.

Le procédé se poursuit par la croissance des cœurs des nano-LEDs.

Par exemple, pour des nano-LEDs **30** décrites en relation avec la figure 2, cette étape débute par croissance localisée de nanofils en GaN dopés n constituant le cœur **34** des nano-LEDs **30,** puis dans une seconde étape de fabrication, un dépôt radial de la zone active **36** est réalisé en formant une alternance de couches fines de barrières GaN et de puits d'InGaN non intentionnellement dopes. Les barrières et les puits pourront avoir une épaisseur de 10 nanomètres et 3 nanomètres respectivement. Par exemple, les cœurs **34** sont réalisée au moyen d'une d'hétéro-épitaxie de GaN sur les contacts **88, 94,** notamment par exemple par MOVPE (pour « *Métal Organic Vapour Phase Epitaxy* »), par MBE (pour « *Molecular Beam Epitaxy* ») ou par HVPE (pour « *Hydride Vapour Phase Epitaxy* ») selon un mode dit spontané, comme décrit au document WO-A-2007/141333 par exemple, ou de façon sélective avec l'aide d'un masque de croissance **200.**

Les coeurs **34** sont soit en contact direct avec le support **58,** soit en contact indirect avec celui-ci, via une fine couche d'AlN ou de SiN$_x$ de quelques nanomètres intercalée entre le support **58** et les coeurs **34.** Cette couche étant très fine, la continuité électrique est toujours vérifiée. Par contre, une telle couche facilite la croissance des nanofils et améliore l'orientation verticale de ceux-ci.

Concernant la fabrication de nano-LEDs **110,** illustrée à la figure 17, une hétéro-épitaxie, par exemple d'InGaN épais, est réalisée sur les contacts **88, 94** afin d'obtenir des cœurs **116.** Cette croissance des cœurs **116** est réalisée par exemple par MOCVD, par MBE ou par HVPE selon un mode spontané ou de façon sélective à l'aide du masque sélectif de croissance **200.** Aucun dopant n'est utilisé au cours de la croissance de l'InGaN qui présente alors un dopage résiduel inférieur à $10^{16}$ électrons/cm$^3$.

Une coquille est alors réalisée autour de chaque cœur, par exemple en GaN ou en InGaN dopé p (figure 18).

Dans le cas de nano-LEDs **110,** le dopage de la coquille, par exemple apporté par un dopage en magnésium, est choisi de l'ordre de $10^{18}$ trous/cm$^3$, et la composition d'indium est soit nulle (GaN-p), ou si elle est différente de 0, inférieure à celle de l'InGaN épais des cœurs **116** pour assurer le confinement des porteurs, puisque l'ajout d'indium dans la zone active diminue le gap du matériau ce qui génère un puits de potentiel pour les porteurs.

Les coquilles sont par exemple réalisées au moyen d'un dépôt radial tel que décrit précédemment. Les coquilles des nano-LEDs sont isolées du support **58** en utilisant un masque de croissance sélectif **200** électriquement isolant SiN$_x$ ou SiO$_2$ par exemple si les cœurs ont été réalisés au moyen d'une croissance sélective ou bien un masque spécifiquement prévu à cet effet est utilisé. Le masque est optionnellement retiré après l'étape de croissance des fils par exemple par gravure chimique.

Le procédé se poursuit alors par le remplissage des espaces entre les nano-LEDs par un matériau planarisant et électriquement isolant **76,** par exemple un diélectrique tel qu'un polymère ou du SiO$_2$, par exemple selon le mode de réalisation décrit dans le brevet WO-A-2009/87319A1 (figure 19). La couche planarisante **76** est déposée de manière à laisser affleurer les têtes des nano-LEDs sur une hauteur supérieure à la hauteur finale souhaitée.

Si un contact d'alimentation inférieur **94** est souhaité, une étape de gravure supplémentaire du matériau planarisant **76** est alors mise en œuvre pour dégager une zone de contact inférieure pour l'injection de courant (figure 19).

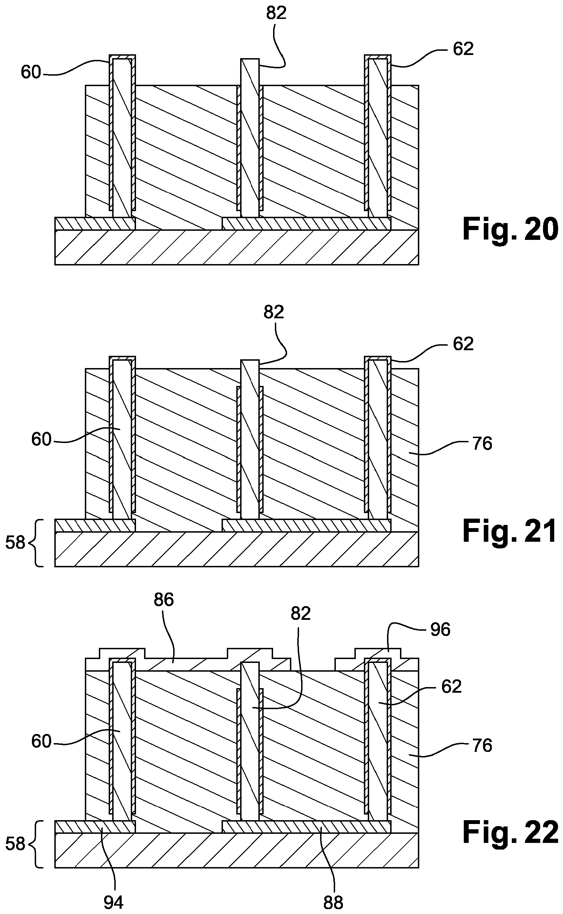

Les nanofils de connexion **82** sont alors formés à partir de nano-LEDs. Notamment, la portion libre des coquilles des nano-LEDs **60, 62** destinées à former des nanofils de connexion est retirée. Par exemple, une étape de lithographie est mise en œuvre pour protéger les nano-LEDs destinées à émettre de la lumière en déposant sur celles-ci un matériau isolant, par exemple du SiO$_2$, puis une gravure chimique ou physique est réalisée, ce qui dégage le cœur des nanofils de connexion (figure 20).

On retire alors le masque de protection des nano-LEDs **60, 62,** puis du matériau isolant et planarisant est à nouveau déposé pour compléter la couche **76** (figure 21).

Le procédé se termine alors par le dépôt des contacts conducteurs **86, 96,** par exemple métalliques (figure 22). Ces contacts sont constitués, au moins au dessus des nano-LEDs **60, 62,** d'un matériau semi-transparent pour permettre l'extraction de la lumière au sommet des nano-LEDs. On peut citer par exemple des fines couches métalliques (Ni/Au, Pd/Au, Pt/Au) ou une couche d'ITO (Indium Tin Oxyde). Une technologie planaire est ainsi utilisée.

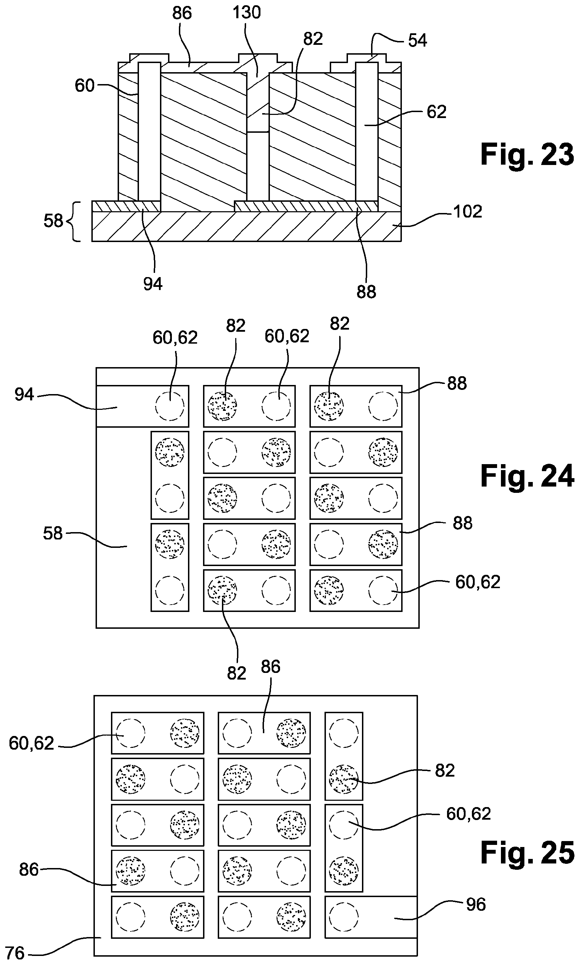

Jusqu'à présent il a été décrit des nano-LEDs du type « core/shell ». Bien évidemment, l'invention s'applique à tout type de LED prenant la forme de nanofils, comme par exemple les nano-LEDs décrites en relation avec la figure 1. Comme illustré à la figure 23, on retrouve sensiblement les mêmes éléments de connexion série entre deux nano-LEDs **60, 62,** les nanofils de connexion **82** étant par exemple réalisés en ôtant la partie supérieure d'une nano-LEDs de manière à libérer la zone **14** et en réalisant en complétant la zone **14** par un nanofil conducteur, par exemple métallique, en contact avec le contact **86.**

Comme précisé précédemment, la connexion en série peut être réalisée de nano-LED à nano-LED ou d'un groupe de nano-LEDs connectées en parallèle à un autre groupe de nano-LEDs connectées en parallèle.

Les figures 24 et 25 illustrent un exemple de matrice de nano-LEDs **60, 62** par trois nano-LEDs **60, 62** connectées en série. La figure 24 est une vue de dessus illustrant les contacts **88** du support, et la figure 25 est une vue de dessus illustrant les contacts **86** sur la couche planarisante **76.**

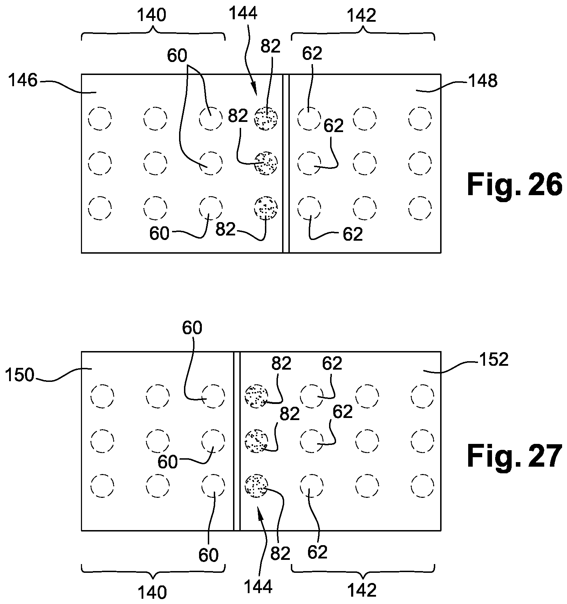

Les figures 26 et 27 illustrent un exemple de connexion en série de deux matrices **140, 142** de trois nano-LEDs par trois nano-LEDs connectées en parallèle, les matrices **140, 142** étant connectées en série par une colonne **144** de nanofils de connexion **82.** La figure 26 est une vue de dessus illustrant un contact **146** du support sur lequel sont formés les nano-LEDs de la matrice **140** et les nanofils de connexion **82,** et un contact **148** du support **58,** électriquement isolé du contact **146,** sur lequel sont formées les nano-LEDs de la matrice **142.** La figure 27 est une vue de dessus illustrant un contact **150** réalisé sur la couche planarisante **76** au contact des nano-LEDs de la matrice **140,** et un contact **152** sur la couche planarisante **76,** électriquement isolé du contact **150** et au contact des nano-LEDs de la matrice **142** et des nanofils de connexion **82.**

Un tel schéma de connexion fiabilise le fonctionnement du dispositif dans le cas où certaines nano-LEDs seraient défectueuses. En outre, il est intéressant de noter que dans le schéma illustré, le nombre de nanofils de connexion **82** est inférieur au nombre de nano-LEDs **60,62** divisé par 2. Le nombre de nanofils de connexion **82** peut cependant être plus élevé, et déterminé en fonction des densités de courant mises en jeu.

En considérant un dispositif émetteur de lumière alimenté par une tension secteur d'environ 240 volts, il est ainsi possible d'envisager, à titre d'exemple, la connexion de 68 nanodiodes ou assemblées de nanodiodes (elles-mêmes connectées en parallèle) et alimentées à une tension moyenne de 3,5 volts.

A chaque passage de courant dans une nano-LED **60,62,** une chute de 3,5 volt en moyenne apparaît. Il est donc possible de brancher directement une assemblée de 68 nano-LEDs connectés en série directement sur une prise d'alimentation domestique à 240 volts, le cas échéant en ajoutant un convertisseur alternatif-continu pour éviter une émission de lumière intermittant en raison du caractère alternatif des réseaux d'électricité domestiques. Il n'est ainsi plus besoin d'utiliser un transformateur pour diminuer la tension d'alimentation.

De plus, en connectant en parallèle au moins deux branches de 68 nano-LEDs présentant des sens de fonctionnement opposés, à savoir présentant une schéma de connexion équivalent à deux diodes tête-bêche en parallèle, il est possible de s'affranchir du convertisseur alternatif-continu puisque chaque branche sera passante tour à tour et la lumière sera émise en continu.

Ce schéma de connexion permet de s'affranchir de l'électronique de contrôle des dispositifs LEDs, qui sont des pièces fragiles qui limitent le temps de vie de ces dispositifs et qui en augmentent fortement les coûts.

Il a été décrit des nano-LEDs constituées de matériau de la famille de matériaux GaN. Les matériaux à gap direct sont également utilisables pour l'émission de lumière, notamment les matériaux à grand gap pour la génération de lumière dans le domaine spectral UV - bleu (ZnO), ou les matériaux petit gap (GaAs, GaP, InP) pour la génération de lumière dans le domaine spectral rouge et infrarouge.

Différents types de substrats peuvent également être envisagés et notamment substrats bons conducteurs thermiques pour une meilleur évacuation de la chaleur.

Il est également possible de concevoir un dispositif émetteur de lumière blanche grâce à l'encapsulation d'un dispositif décrit précédemment dans un matériau contenant des phosphores.

Il est également possible de concevoir un dispositif émetteur de lumière blanche grâce à la connexion en série de différentes catégories de nano-LEDs : une catégorie émettant dans le bleu, une deuxième catégorie émettant dans le vert, et une troisième catégorie émettant dans le rouge. Par exemple, pour chaque catégorie, des nano-LEDs, par exemple du type « *Core/Shell* », sont connectées en parallèle. La modulation de la longueur d'onde émise est avantageusement obtenue en modifiant le diamètre des fils, ce qui est rendu aisé par la méthode de croissance choisie, à savoir avantageusement une croissance localisée.

Grâce à l'invention, il est donc possible de mettre en œuvre une connexion électrique en série de nano-LEDs, ce qui a notamment pour avantage de permettre :

- une interconnexion de longueur illimitée ;
- une homogénéité de la densité de courant injectée pour alimenter les nano-LEDs, et corolairement une intensité lumineuse stable et une limitation de l'apparition de points de chauffe qui peuvent endommager les matériaux (notamment les contacts) ;
- une tension d'alimentation globale importante, les amenées de courant sont donc parcourues par un courant moins important, ce qui fiabilise le fonctionnement du dispositif tout en maintenant une puissance électrique injectée constante ;
- une commande en tensions alternatives ou continues possible puisqu'il est notamment possible d'alimenter les nano-LEDs par la tension du réseau domestique sans utiliser de transformateurs ou de convertisseurs alternatif-continu.

**Revendications**

1. Dispositif optoélectronique comportant au moins :

   ▪ un premier et un deuxième nanofils émetteurs de lumière (60, 62) formés sur un support (58) et comportant chacun une zone semi-conductrice d'un premier type (68, 70) pour l'injection de trous et une zone semi-conductrice d'un second type (72, 74) pour l'injection d'électrons ;
   ▪ une connexion électrique en série des premier et deuxième nanofils émetteurs de lumière (60, 62) comportant :

      ◦ un nanofil semiconducteur de connexion (82) formé sur le support (58) et comprenant :

         • une première région (84) apte à former avec la zone d'injection de trous (68) du premier nanofil (60) un chemin électrique permettant la circulation d'un courant électrique ;
         • une deuxième région (90) apte à former avec la zone d'injection d'électrons (74) du second nanofil (62) un chemin électrique permettant la circulation d'un courant électrique ; et
         • une troisième région (92) au contact des première et deuxième régions (84, 90) permettant la circulation d'un courant électrique entre celles-ci ;

      ◦ une première zone conductrice (86) connectant la zone d'injection de trous (68) du premier nanofil (60) et la première région (84) du nanofil de connexion (82) et électriquement isolée du deuxième nanofil (62); et
      ◦ une deuxième zone conductrice (88) connectant la deuxième région (90) du nanofil de connexion (82) et la zone d'injection d'électrons (74) du deuxième nanofil (62) et isolée électriquement du premier nanofil (60) ;

   chacun des premier et deuxième nanofils émetteur de lumière (60, 62) comprenant un cœur semi-conducteur (64, 66) dont l'extrémité (72, 74) formée sur le support (58) constitue l'une des zones parmi la zone d'injection de trous et la zone d'injection d'électrons, et une coquille semi-conductrice (68, 70) enrobant le cœur (64, 66) sur au moins une portion supérieure de celui-ci et constituant l'autre parmi la zone d'injection de trous et la zone d'injection d'électrons ;

      ▪ le cœur (116) des premier et deuxième nanofils (60, 62) étant constitué d'un matériau semi-conducteur d'un première type de conductivité ;
      ▪ la coquille (118) des premier et deuxième nanofils (60, 62) étant constituée d'un matériau semi-conducteur d'un deuxième type de conductivité opposé au premier type de conductivité ; et
      ▪ le nanofil de connexion (82) comportant au moins un cœur constitué du matériau du premier type de conductivité.

2. Dispositif optoélectronique selon la revendication 1, dans lequel le nanofil de connexion (82) comporte un cœur semi-conducteur du premier type dépourvu de coquille sur au moins une première et une deuxième portion formant respectivement la première et la deuxième région du nanofil de connexion.

3. Dispositif optoélectronique selon la revendication 2, dans lequel la première portion du cœur du nanofil de connexion dépourvue de coquille comporte l'extrémité du nanofil opposée au support.

4. Dispositif optoélectronique selon l'une des revendications 1 à 2, dans lequel le nanofil de connexion est constitué d'un matériau conducteur.

5. Dispositif optoélectronique selon l'une quelconque des revendications précédentes, dans lequel le support (58) comporte une couche électriquement isolante plane (102) sur laquelle est réalisé un contact conducteur plan (88) formant la deuxième zone conductrice et sur lequel le nanofil de connexion (82) et le deuxième nanofil émetteur de lumière (60) sont formés.

6. Dispositif optoélectronique selon l'une quelconque des revendications précédentes, dans lequel les nanofils (60, 62, 82) sont noyés dans une couche électriquement isolante et plane (76), les extrémités (78, 80, 84) des nanofils opposées au support (58) affleurant de ladite couche (76), et sur laquelle est réalisé un contact conducteur (86) formant la première zone conductrice et enrobant les extrémités affleurantes (78, 84) du premier nanofil (60) et du nanofil de connexion (82).

**7.** Dispositif optoélectronique selon l'une quelconque des revendications précédentes, comprenant un réseau de nanofils émetteurs de lumière connectés en série par des connexions électriques en série.

**8.** Dispositif optoélectronique selon l'une quelconque des revendications précédentes, comprenant un réseau de nanofils émetteurs de lumière constitué d'au moins deux ensembles (140, 142) de nanofils émetteurs de lumière connectés électriquement en parallèle, au moins un nanofil d'un ensemble étant connecté en série avec un nanofil de l'autre ensemble par une connexion électrique en série.

**9.** Procédé de fabrication d'un dispositif optoélectronique comportant au moins un premier et un deuxième nanofils émetteurs de lumière formés sur un support et comportant un cœur semi-conducteur dont l'extrémité formée sur le support constitue l'une des zones parmi une zone d'injection de trous et une zone d'injection d'électrons, et une coquille semi-conductrice enrobant le cœur sur au moins une portion supérieure de celui-ci et constituant l'autre parmi la zone d'injection de trous et la zone d'injection d'électrons, ledit procédé consistant :

- à réaliser un support comportant une couche électrique isolante (102) sur laquelle est formé une couche conductrice inférieure (88) ;
- à réaliser sur le support trois nanofils identiques comportant chacun un cœur semi-conducteur d'un premier type et une coquille semi-conductrice d'un second type enrobant le cœur sur au moins une portion supérieure de celui-ci, deux des nanofils étant réalisés sur ladite couche conductrice inférieure (88)
- à déposer une couche plane et électriquement isolante sur le support de manière à enrober les nanofils tout en laissant leurs extrémités libres affleurer de ladite couche plane ;
- à retirer une partie de la coquille sur l'extrémité libre de l'un des deux nanofils formés sur la couche conductrice inférieure (88) de manière à libérer le cœur de celui-ci, ce nanofil étant destiné à devenir un nanofil de connexion, les deux autres nanofils desdites trois nanofils identiques étant destinés à devenir des nanofils émetteurs de lumière ; et
- à déposer un contact électrique supérieur sur la couche plane et isolante de manière à enrober l'extrémité libre du nanofil qui n'est pas réalisé sur la couche conductrice inférieure et l'extrémité libre du nanofil de connexion ayant subi le retrait d'une partie de sa coquille ;

chacun des premier et deuxième nanofils émetteur de lumière (60, 62) comprenant un cœur semi-conducteur (64, 66) dont l'extrémité (72, 74) formée sur le support (58) constitue l'une des zones parmi la zone d'injection de trous et la zone d'injection d'électrons, et une coquille semi-conductrice (68, 70) enrobant le cœur (64, 66) sur au moins une portion supérieure de celui-ci et constituant l'autre parmi la zone d'injection de trous et la zone d'injection d'électrons ;

- le cœur (116) des premier et deuxième nanofils (60, 62) étant constitué d'un matériau semi-conducteur d'un première type de conductivité ;
- la coquille (118) des premier et deuxième nanofils (60, 62) étant constituée d'un matériau semi-conducteur d'un deuxième type de conductivité opposé au premier type de conductivité ; et
- le nanofil de connexion (82) comportant au moins un cœur constitué du matériau du premier type de conductivité.

**Patentansprüche**

**1.** Optoelektronische Vorrichtung, die mindestens umfasst:

• einen ersten und einen zweiten lichtemittierenden Nanodraht (60, 62), gebildet auf einem Träger (58), die jeweils eine Halbleiterzone eines ersten Typs (68, 70) zum Einspritzen von Löchern und eine zweite Halbleiterzone eines zweiten Typs (72, 74) zum Einspritzen von Elektronen enthalten;
• eine elektrische Reihenschaltung mit den ersten und zweiten lichtemittierenden Nanodrähten (60, 62), mit:

o einem Halbleiter- Verbindungsnanodraht (82) gebildet auf dem Träger (58), der enthält:

- einen ersten Bereich (84), der einen elektrischen Pfad mit dem Lochinjektionsbereich (68) des ersten Nanodrahts (60) bilden kann, der es ermöglicht, dass ein elektrischer Strom fließen kann,
- einen zweiten Bereich (90), der einen elektrischen Pfad mit dem Elektroneninjektionsbereich (74) des zweiten Nanodrahts (62) bilden kann; und
- einen dritten Bereich (92), der mit dem ersten und zweiten Bereich (84, 90) Kontakt hat und der es ermöglicht, dass ein Strom zwischen diesen beiden Bereichen fließt;

o eine erste leitende Zone (86), die die Lochinjektionszone (68) des ersten Nanodrahts (60) und den ersten Bereich (84) des Verbindungsnanodrahts (82) verbindet und vom zweiten Nanodraht (62) elektrisch isoliert; und

o eine zweite leitende Zone (88) die den zweiten Bereich (90) des Verbindungsnanodrahts (82) und den Elektroneninjektionszone (74) des zweiten Nanodrahtes (62) verbindet und vom ersten Nanodraht elektrisch isoliert ist.

jeder der ersten und zweiten lichtemittierenden Nanodrähte (60, 62) enthält einen Halbleiterkern (64, 66) dessen Endstück (72, 74), gebildet auf dem Träger (58) eine der Zonen der Lochinjektionszone und der Elektroneninjektionszone bildet sowie eine Halbleiter- Umhüllung (68, 70), die den Kern (64, 66) zumindest in einem seiner oberen Abschnitte ummantelt und die die jeweils andere der Lochinjektionszone oder der Elektroneninjektionszone bildet;

• der Kern (116) der ersten und zweiten Nanodrähte (60, 62) besteht dabei aus einem Halbleitermaterial eines ersten Konduktivitätstyps;
• die Umhüllung (118) der ersten und zweiten Nanodrähte (60, 62) besteht dabei aus einem Halbleitermaterial eines zweiten Konduktivitätstyps, der dem ersten Konduktivitätstyp entgegengesetzt ist; und
• der Verbindungsnanodraht (82) enthält mindestens einen Kern, bestehend aus Material des ersten Konduktivitätstyps.

2. Optoelektronische Vorrichtung nach Anspruch 1, bei dem der Verbindungsnanodraht (82) einen Halbleiterkern des ersten Typs ohne Umhüllung in mindestens einem ersten und einem zweiten Abschnitt enthält, die jeweils den ersten und den zweiten Bereich des Verbindungsnanodrahtes bilden.

3. Optoelektronische Vorrichtung nach Anspruch 2, bei der der erste Abschnitt des Kerns des Verbindungsnanodrahtes ohne Umhüllung das Endstück des dem Träger entgegengesetzten Nanodrahtes enthält.

4. Optoelektronische Vorrichtung nach einem der Ansprüche 1 bis 2, bei dem der Verbindungsnanodraht aus einem leitenden Material besteht.

5. Optoelektronische Vorrichtung nach irgendeinem der vorangehenden Ansprüche, bei dem der Träger(58) eine elektrische isolierende, plane Fläche (102) enthält, auf der ein planer, leitender Kontakt (88) ausgeführt ist, der die zweite leitende Zone bildet und auf dem der Verbindungsnanodraht und (82) der zweite lichtaussendende Nanodraht (60) gebildet sind.

6. Optoelektronische Vorrichtung nach irgendeinem der vorangehenden Ansprüche, bei dem die Nanodrähte (60, 62, 82) in eine elektrisch isolierende, plane Schicht (76) eingebettet sind, die Endstücke (78, 80, 84) der Nanodrähte entgegengesetzt zum Träger (58), der an diese Schicht (76) angrenzt und auf der ein leitender Kontakt (86) ausgeführt ist, der die erste leitende Zone bildet und die benachbarten Endstücke (78, 84) des ersten Nanodrahtes (60) und des Verbindungsnanodrahtes (82) ummantelt.

7. Optoelektronische Vorrichtung nach irgendeinem der vorangehenden Ansprüche, mit einem Netz lichtemittierender Nanodrähte, in Reihe geschaltet durch elektrische Reihenschaltungen.

8. Optoelektronische Vorrichtung nach irgendeinem der vorangehenden Ansprüche, mit einem Netz lichtemittierenden Nanodrähte, bestehend aus mindestens zwei Baugruppen (140, 142) lichtemittierender Nanodrähte, parallel geschaltet, mindestens ein Nanodraht der Baugruppe ist über eine elektrische Reihenschaltung, in Reihe mit einem Nanodraht der anderen geschaltet,.

9. Verfahren zur Herstellung einer optoelektronischen Vorrichtung mit mindestens einem ersten und einem zweiten lichtemittierenden Nanodraht, gebildet auf dem Träger und mit einem Halbleiterkern, dessen auf dem Träger gebildetes Endstück eine der Zonen der Lochinjektionszone und der Elektroneninjektionszone bildet, sowie einer Halbleiter- Umhüllung, die den Kern zumindest in einem seiner oberen Abschnitte ummantelt und die jeweils andere der Lochinjektionszone oder der Elektroneninjektionszone bildet, dieses Verfahren besteht darin:

- einen Träger herzustellen, der eine elektrisch isolierende Schicht (102) enthält, auf der eine untere leitende Schicht (88) gebildet ist;
- auf dem Träger drei identische Nanodrähte herzustellen, die jeweils einen Halbleiter- Kern eines ersten Typs enthalten sowie eine Halbleiter- Umhüllung eines zweiten Typs, die den Kern über mindestens einen Teil seines oberen Abschnitts ummantelt, dabei sind zwei Nanodrähte auf der erwähnten unteren leitenden Schicht (88) ausgeführt
- eine plane und elektrisch isolierende Schicht abzuscheiden, so dass die Nanodrähte umhüllt werden, wobei ihre Endstücke, die diese plane Schicht berühren, frei bleiben;
- einen Teil der Umhüllung am freien Endstück eines der beiden Nanodrähte, die auf der unteren leitenden Schicht (88) geformt sind, zu entfernen, so dass sein Kern freigelegt wird, dieser Nanodraht ist dazu bestimmt, ein Verbindungsnanodraht zu werden, die beiden anderen Nanodrähte dieser drei identischen Nanodrähte sollen zu lichtaussendenden Nanodrähten werden; und
- einen oberen elektrischen Kontakt auf der planen, isolierenden Schicht abzuscheiden, so dass das freie Endstück des Nanodrahtes, das nicht auf der unteren leitenden Schicht gebildet wird und das freie Endstück des Verbindungsnanodrahtes, bei dem ein Teil der Umhüllung entfernt wurde, zu ummanteln;

jeder der ersten und zweiten lichtemittierenden Nanodrähte (60, 62) enthält einen Halbleiterkern (64, 66) dessen Endstück (72, 74), gebildet auf dem Träger (58), eine der Zonen der Lochinjektionszone und der Elektroneninjektionszone bildet sowie eine Halbleiter- Umhüllung (68, 70), die den Kern (64, 66) zumindest in einem seiner oberen Abschnitte ummantelt und wobei die jeweils andere die Lochinjektionszone bzw. die Elektroneninjektionszone bildet;

- der Kern (116) der ersten und zweiten Nanodrähte (60, 62) besteht dabei aus einem Halbleitermaterial eines ersten Konduktivitätstyps;
- die Umhüllung (118) der ersten und zweiten Nanodrähte (60, 62) besteht dabei aus einem Halbleitermaterial eines zweiten Konduktivitätstyps, der dem ersten Konduktivitätstyp entgegengesetzt ist; und
- der Verbindungsnanodraht (82) enthält mindestens einen Kern, bestehend aus Material des ersten Konduktivitätstyps.

## Claims

1. An optoelectronic device comprising at least:

   ▪ a first and a second light-emitting nanowires (60, 62) formed on a support (58) and each comprising a semiconductor area of a first type (68, 70) for the injection of holes and a semiconductor area of a second type (72, 74) for the injection of electrons;
   ▪ a series electric connection of the first and second light-emitting nanowires (60, 62) comprising:

      ◦ a semiconductor connection nanowire (82) formed on the support (58) and comprising:

         • a first region (84) capable of forming with the hole injection area (68) of the first nanowire (60) an electric path enabling an electric current to flow;
         • a second region (90) capable of forming with the electron injection area (74) of the second nanowire (62) an electric path enabling an electric current to flow; and
         • a third region (92) in contact with the first and second regions (84, 90) enabling an electric current to flow therebetween;

      o a first conductive area (86) connecting the hole injection area (68) of the first nanowire (60) and the first region (84) of the connection nanowire (82) and electrically insulated from the second nanowire (62); and
      o a second conductive area (88) connecting the second region (90) of the connection nanowire (82) and the electron injection area (74) of the second nanowire (62) and electrically insulated from the first nanowire (60) ;

   each of the first and second light-emitting nanowires (60, 62) comprising a semiconductor core (64, 66) having its end (72, 74) formed on the support (58) forming the hole injection area or the electron injection area, and a semiconductor shell (68, 70) surrounding the core (64, 66) at least over an upper portion thereof and forming the other area among the hole injection area and the electron injection area;

- the core (116) of the first and second nanowires (60, 62) being formed of a semiconductor material or a first conductivity type;
- the shell (118) of the first and second nanowires (60, 62) being formed of a semiconductor material of a second conductivity type, opposite to the first conductivity type; and
- the connection nanowire (82) comprising at least one core made of the material of the first conductivity type.

2. The optoelectronic device of claim 1, wherein the connection nanowire (82) comprises a semiconductor core of the first type having no shell on at least a first and a second portion respectively forming the first and the second region of the connection nanowire.

3. The optoelectronic device of claim 2, wherein the first portion of the core of the connection nanowire comprising no shell comprises the nanowire end opposite to the support.

4. The optoelectronic device of any of claims 1 and 2, wherein the connection nanowire is made of a conductive material.

5. The optoelectronic device of any of the foregoing claims, wherein the support (58) comprises a planar electrically-insulating layer (102) having a planar conductive contact (88) forming the second conductive area formed thereon, said contact having the connection nanowire (82) and the second light-emitting nanowire (60) formed thereon.

6. The optoelectronic device of any of the foregoing claims, wherein the nanowires (60, 62, 82) are embedded in an electrically-insulating and planar layer (76), the ends (78, 80, 84) of the nanowires opposite to the support (58) slightly emerging from said layer (76), said layer having a conductive contact (86) forming the first conductive area and surrounding the emerging ends (78, 84) of the first nanowire (60) and of the connection nanowire (82) formed thereon.

7. The optoelectronic device of any of the foregoing claims, comprising a network of light-emitting nanowires series-connected by series electric connections.

8. The optoelectronic device of any of the foregoing claims, comprising a network of light-emitting nanowires formed of at least two assemblies (140, 142) of light-emitting nanowires electrically connected in parallel, at least one nanowire of an assembly being series-connected with a nanowire of the other assembly by a series electric connection.

9. A method for manufacturing an optoelectronic device comprising at least one first and one second light-emitting nanowires formed on a support and comprising a semiconductor core having its end formed on the support forming a hole injection area or an electron injection area, and a semiconductor shell surrounding the core at least over an upper portion thereof and forming the other area among the hole injection area and the electron injection area, said method comprising:

- forming a support comprising an electrically-insulating layer (102) having a lower conductive layer (88) formed thereon;
- forming on the support three identical nanowires, each comprising a semiconductor core of a first type and a semiconductor shell of a second type surrounding the core over at least an upper portion thereof, two of the nanowires being formed on said lower conductive layer (88);
- depositing a planar and electrically-insulating layer on the support to coat the nanowires while letting their free ends slightly emerge from said planar layer;
- removing a portion of the shell from the free end of one of the two nanowires formed on the lower conductive layer (88) to disengage the core thereof; said nanowire being intended to become a conductive nanowire, the two others nanowires of said three identical nanowires being intended to become light-emitting nanowires; and
- depositing an upper electric contact on the planar insulating layer to coat the free end of the nanowire which is not formed on the lower conductive layer and the free end of the conductive nanowire having had a portion of its shell removed;

each of the first and second light-emitting nanowires (60, 62) comprising a semiconductor core (64, 66) having its end (72, 74) formed on the support (58) forming the hole injection area or the electron injection area, and a semiconductor shell (68, 70) surrounding the core (64, 66) at least over an upper portion thereof and forming the other area among the hole injection area and the electron injection area;

- the core (116) of the first and second nanowires (60, 62) being formed of a semiconductor material or a first conductivity type;
- the shell (118) of the first and second nanowires (60, 62) being formed of a semiconductor material of a second conductivity type, opposite to the first conductivity type; and
- the connection nanowire (82) comprising at least one core made of the material of the first conductivity type.

**Fig. 1**

(Etat de la technique)

**Fig. 2**

(Etat de la technique)

EP 2 710 634 B1

50

10;30

12;32

A A

## Fig. 3
(Etat de la technique)

54

10;30

52

12;32

56

## Fig. 4
(Etat de la technique)

**Fig. 5**

**Fig. 6a**

**Fig. 6c**

**Fig. 6b**

**Fig. 7**

**Fig. 8**

**Fig. 9**

Fig. 10

Fig. 11

Fig. 12

**Fig. 13**

**Fig. 14**

**Fig. 15**

94      88

58

**Fig. 16**

102

116    116    116

200

58

**Fig. 17**

102

94      88

60    118    118    62

116    116    116    118

**Fig. 18**

58

102

60    62

76

**Fig. 19**

58

102

94      88

82

60

62

**Fig. 20**

82

62

60

76

58 {

**Fig. 21**

86

82

96

60

62

76

58 {

94

88

**Fig. 22**

Fig. 23

Fig. 24

Fig. 25

Fig. 26

Fig. 27

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20050253138 A
- US 20070057248 A
- US 20080157057 A
- WO 2008048704 A
- WO 200814061 A
- WO 2010071594 A
- US 7535028 B
- WO 2011020959 A
- WO 2007141333 A
- WO 200987319A1 A

**Littérature non-brevet citée dans la description**

- **N.F. GARDNER et al.** Blue-emitting InGaN-GaN double-heterostructure light-emitting diodes reaching maximum quantum efficiency above 200 A/cm. *Applied Physics Letters,* 2007, vol. 91, 243506